# FASCICULE DE BREVET EUROPEEN

(11) **EP 2 298 693 B1**
(45) Date de publication et mention de la délivrance du brevet: **11.07.2012**
(21) Numéro de dépôt: 10177290.3
(22) Date de dépôt: 17.09.2010
(51) Int. Cl.: B81B 5/00, B82Y 15/00, B82Y 30/00

(54) **Réalisation d'un composant électromecanique pour un micro- ou nano- système doté d'un barreau formant un axe de rotation du composant et recouvert de graphène**
Verfahren zur Herstellung eines elektromechanischen Bauelementes für ein Mikro- oder Nano-System mit einem eine Rotationsachse des Bauelementes bildenden mit Graphen überzogenen Stab
Process for forming an electromechanical component for a micro- or nano-system having a rod which forms the rotation axis of the component, the rod being covered with graphene

(30) Priorité: 18.09.2009 FR 0956426
(43) Date de publication de la demande: 23.03.2011
(73) Titulaire: Commissariat à l'Énergie Atomique et aux Énergies Alternatives, 75015 Paris (FR)
(72) Inventeur: Gabriel, Jean-Christophe, 38950 QUAIX-EN-CHARTREUSE (FR); Andreucci, Philippe, 38430 MOIRANS (FR); Ernst, Thomas, 38210 MORETTE (FR); Poiroux, Thierry, 38500 VOIRON (FR)
(74) Mandataire: Ilgart, Jean-Christophe

(56) Documents cités:
- WO-A2-2005/008708
- WO-A2-2006/090400
- WO-A2-2007/119123
- WO-A2-2009/102902
- GB-A- 2 422 638
- US-A1- 2004 004 485
- US-A1- 2009 020 399

## Description

### DOMAINE TECHNIQUE

La présente invention se rapporte au domaine des microsystèmes (MEMS) et/ou des nano-systèmes électromécaniques (NEMS).

Elle concerne un procédé de mise en oeuvre d'un composant électromécanique, pour NEMS ou MEMS, doté d'au moins un organe fixe formant un axe de rotation et d'au moins un organe mobile en rotation autour de l'organe mobile.

Elle apporte des améliorations en termes de fiabilité, de robustesse, tout en permettant la réalisation de composants de faible taille dans lesquels les phénomènes de frottement sont améliorés, et les forces nécessaires à l'actionnement de l'organe mobile sont diminuées.

L'invention permet de faciliter la réalisation de l'actionnement et/ou du maintien en position stable de l'organe mobile.

Elle trouve des applications dans de nombreux domaines tels que les commutateurs optiques ou électriques ou mécaniques, les micro- ou nano- moteurs, les micro- ou nano- turbines.

### ÉTAT DE LA TECHNIQUE ANTÉRIEURE

Les micro-systèmes électromécaniques (MEMS) ou nano-systèmes électromécaniques (NEMS) sont des systèmes comprenant un ou plusieurs éléments mécaniques, utilisant l'électricité ou de la chaleur comme source d'énergie, en vue de réaliser une fonction de capteur et/ou d'actionneur, et sont dotés d'au moins une structure présentant des dimensions micrométriques dans le cas d'un microsystème, ou nanométriques dans le cas d'un nano-système.

Les systèmes MEMS ou NEMS peuvent être fabriqués à l'aide de techniques issues de la de la micro-électronique qui permettent une production à grande échelle.

Il est connu de réaliser des micro-composants, ou nano-composants électromécaniques dotés d'un élément ou organe formant un axe de rotation autour duquel un organe mobile se déplace.

Le document WO 2009/102902 concerne un procédé de réalisation d'un microsystème électromécanique doté d'un organe mobile en rotation autour d'un nanotube de carbone à parois multiples formé par croissance ou soudure sur un substrat.

Le document WO 01/16054 A2 divulgue un tel type de composant, sous forme d'un micro-moteur doté d'un organe fixe formant un axe de rotation horizontal muni d'une ailette centrale en rotation autour dudit élément. Cet organe fixe est réalisé à l'aide d'un nanotube.

Le nanotube est fabriqué soit à part, puis déposé sur un substrat, ou bien peut être réalisé par croissance catalytique.

Dans les deux cas, la réalisation d'un tel élément pose problème.

Il est notamment difficile de maîtriser le diamètre du nanotube, et lorsque plusieurs nanotubes doivent être réalisés, de maitriser la dispersion entre les diamètres respectifs des nanotubes de carbone.

Cela a pour conséquence de rendre la réalisation des éléments situés autour du ou des organes fixes du composant, délicate.

Dans le cas de la réalisation par dépôt d'un nanotube formant un axe de rotation, un positionnement exact de ce nanotube est également difficile à obtenir, et nécessite généralement un traitement de surface approprié ou une fabrication d'un réceptacle approprié tel qu'une encoche. Sans un tel réceptacle ou un tel traitement, le positionnement du nanotube de manière symétrique par rapport à ses deux points d'ancrage s'avère problématique.

Outre le problème de positionnement des nanotubes, une réalisation d'un dispositif comprenant une pluralité de nanotubes de carbone formant chacun un axe de rotation, pose problème.

En effet, le dépôt de nanotubes nécessite généralement l'apport de catalyseurs dont la mise en oeuvre n'est pas toujours compatible avec certaines autres étapes du procédé de fabrication.

Lorsque le nanotube est réalisé par croissance, les interfaces mécaniques au niveau des ancrages peuvent être fragilisées du fait de l'utilisation d'un tel catalyseur externe.

D'autre part, la mise en oeuvre d'axe de rotation à l'aide de nanotubes pose problème au niveau des points d'ancrages de ces derniers qui peuvent consituer des points de faiblesse mécanique de la structure, la surface de contact d'un nanotube au niveau de ses points d'ancrages étant réduite.

Un axe de rotation formé d'un nanotube peut également s'avérer insuffisamment rigide pour certaines applications nécessitant la réalisation d'un organe mobile de poids important et peut conduire à une flexion du nanotube et donc à un mauvais contrôle de la rotation et à de mauvaises performances du moteur.

La réalisation d'un micromoteur à axe de rotation formé d'un nanotube pose également des difficultés au niveau de la réalisation des connexions électriques.

Il se pose le problème de mettre en oeuvre un composant électromécanique pour micro-système ou nano-système à organe fixe formant un axe de rotation et doté d'un organe mobile, amélioré notamment en termes de robustesse et de fiabilité.

### EXPOSÉ DE L'INVENTION

L'invention concerne tout d'abord un procédé de réalisation d'un micro-système électromécanique doté d'au moins un organe fixe comprenant un barreau, et d'au moins un organe mobile en rotation autour d'au moins une portion du dit barreau, le procédé comprenant des étapes de :
a) formation à partir d'une couche, d'au moins un matériau donné reposant sur un support, d'au moins un barreau, ledit matériau donné étant compatible avec une croissance de feuillets de graphène, ou comportant au moins une épaisseur qui peut être traitée de manière à être décomposée et transformée en un empilement de plusieurs feuillets de graphène,
b) formation autour du barreau d'au moins un premier feuillet de graphène, et d'au moins un deuxième feuillet de graphène, séparé du premier feuillet et mobile par rapport au premier feuillet, ledit deuxième feuillet de graphène étant destiné à former une partie d'organe mobile du micro-système électromécanique.

Un tel agencement des feuillets de graphène permet de former un composant dans lequel les phénomènes de frottement sont limités.

Un tel agencement des feuillets de graphène permet de former un composant dans lequel les phénomènes de torsion du barreau formant l'axe de rotation sont supprimés ou fortement diminués.

En évitant l'effet de torsion du barreau, on rend l'actionnement plus aisé. On permet également un actionnement, et/ou un maintien du composant dans une position stable, en mettant en oeuvre des forces d'intensités plus faibles que dans des dispositifs suivant l'art antérieur dans lesquels une torsion d'un élément jouant le rôle d'axe de rotation est nécessairement mise en oeuvre.

Une gravure de ladite couche du dit matériau donné est réalisée pour former ledit barreau. Le barreau ainsi formé est plein.

Le matériau donné est un matériau sur lequel une croissance de graphène peut être réalisé ou à partir duquel du graphène peut être formé par décomposition du matériau donné.

Le matériau donné peut être du SiC ou du cuivre (Cu) ou du Nickel (Ni) ou de l'iridium (Ir) ou du platine (Pt) ou du ruthenium (Ru) ou du Palladium (Pd).

Préalablement à l'étape b), on forme un matériau sur lequel une croissance de graphène peut être réalisé ou à partir duquel du graphène peut être formé.

Le matériau choisi peut être du carbone amorphe.

Selon une première possibilité de mise en oeuvre, le barreau peut être réalisé à l'étape a), de manière à former un angle non-nul, en particulier de 90°, avec le plan principal du support.

Après l'étape a), et préalablement à l'étape b), la gravure du barreau de manière à lui conférer une forme évasée de sa base vers son sommet.

Selon une deuxième possibilité de mise en oeuvre, le barreau formé à l'étape a), peut être parallèle au plan principal du support.

Le barreau peut être alors formé de manière à être rattaché à au moins une zone d'un bloc d'ancrage, ladite zone appartenant à ladite couche de matériau donné. Cela peut permettre de former un ancrage robuste du barreau.

Le barreau peut être formé à travers un bloc de masquage de dimension critique supérieure à celle du barreau et que l'on conserve lorsque les feuillets de graphène sont formés, le graphène recouvrant également ce masquage. Cela peut permettre de former un ancrage robuste de l'organe mobile.

Le procédé peut comprendre en outre : la formation sur le barreau d'au moins un élément de l'organe mobile solidaire du deuxième feuillet de graphène.

Cet élément peut être par exemple sous forme d'une ou plusieurs ailettes, par exemple des ailettes métalliques.

Le procédé peut comprendre en outre entre l'étape a) et l'étape b), au moins une étape consistant à arrondir le profil du barreau.

Selon une mise en oeuvre possible des feuillets de graphène, au moins un des dits feuillets peut former une couche continue autour du barreau.

Les feuillets peuvent être formés de sorte que le pourtour du barreau comporte plusieurs feuillets distincts.

L'invention prévoit également une réalisation d'un micro-commutateur (ou nano-commutateur), ou d'un micromoteur (ou nano-moteur), ou d'une microturbine (ou nano-turbine) à l'aide d'un procédé tel que défini précédemment.

Le procédé selon l'invention aboutit à un système électromécanique de type MEMS ou NEMS, doté d'au moins un composant électromécanique comprenant :
- au moins un organe fixe comprenant un barreau formant un axe de rotation, le barreau étant en au moins un matériau donné et recouvert d'au moins un premier feuillet de graphène,
- au moins un organe mobile en rotation autour du barreau dudit axe de rotation, l'organe mobile comportant au moins un deuxième feuillet de graphène mobile en rotation autour d'au moins une portion dudit barreau recouvert du premier feuillet.

Selon une première possibilité de mise en oeuvre, le barreau peut réaliser un angle non-nul, en particulier de 90°, avec le plan principal du support.

Le barreau peut comporter une base reposant sur le support, le barreau ayant une forme évasée de la base vers son sommet.

Selon une deuxième possibilité de mise en oeuvre, le barreau peut être parallèle au plan principal du support.

Dans ce cas, selon une mise en oeuvre possible, le barreau peut comporter au moins une extrémité rattachée à une zone d'un bloc d'ancrage reposant sur le support, ladite zone et le barreau appartenant à une même couche de matériau. Un ancrage plus robuste peut être ainsi obtenu.

Un élément de maintien et/ou de protection peut être prévu sur le sommet du barreau.

L'organe mobile peut comporter un ou plusieurs éléments mobiles tels que des ailettes, solidaires du deuxième feuillet de graphène et mobiles en rotation autour du barreau.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1J illustrent un premier exemple de procédé de réalisation sur un support d'un composant électro-mécanique suivant l'invention, doté d'un axe de rotation orthogonal au support,
- les figures 2A-2B illustrent une structure à l'interface entre un organe fixe et un organe mobile d'un composant électro-mécanique suivant l'invention,
- les figures 3A-3G illustrent un deuxième exemple de procédé de réalisation sur un support d'un composant électro-mécanique suivant l'invention, doté d'un axe de rotation orthogonal au support,
- les figures 4A-4C illustrent un troisième exemple de procédé de réalisation sur un support d'un composant électro-mécanique suivant l'invention, doté d'un axe de rotation orthogonal au support,
- les figures 5A-5I, 6A-6H illustrent un exemple de procédé de réalisation sur un support d'un composant électro-mécanique suivant l'invention, doté d'un axe de rotation parallèle au support,
- les figures 7A-7K illustrent un exemple de procédé de réalisation sur un support d'un composant électro-mécanique suivant l'invention, doté d'un axe de rotation parallèle au support,
- les figures 8A-8G illustrent un exemple de procédé de réalisation sur un support d'un composant électro-mécanique suivant l'invention, doté d'un axe de rotation parallèle au support,
- la figure 9 illustre un exemple de commutateur bistable formé à l'aide d'un composant électro-mécanique suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

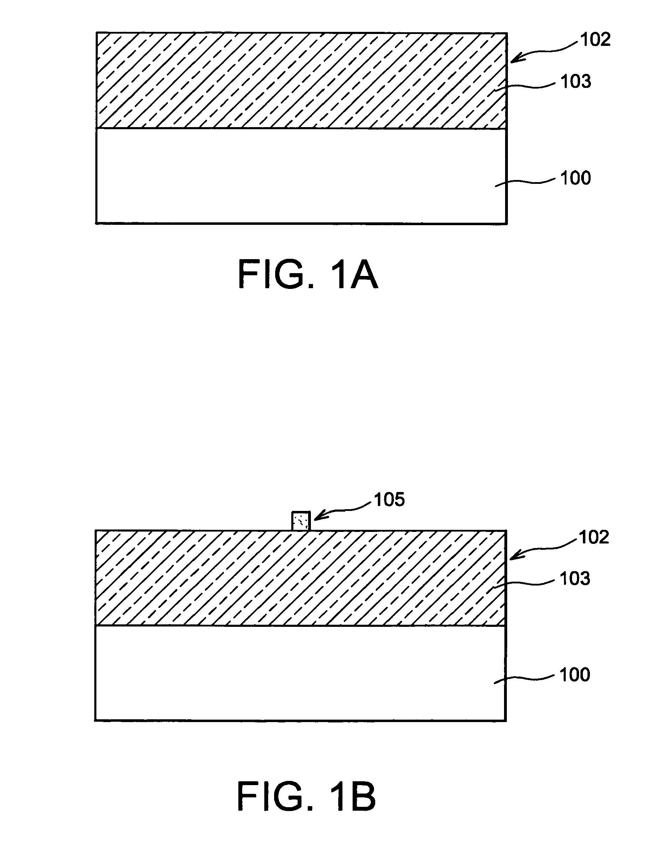

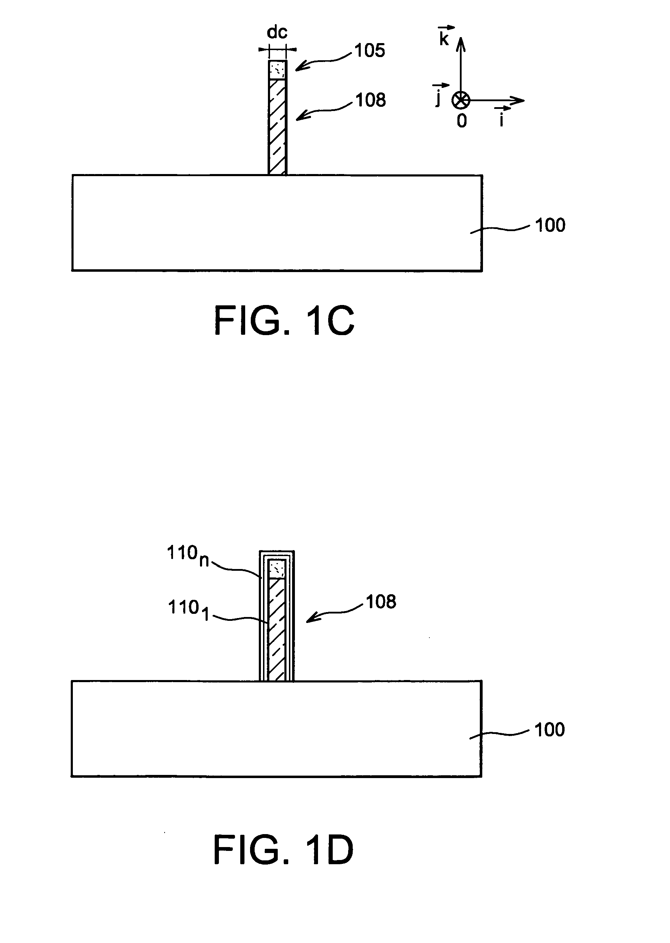

Un premier exemple de procédé de réalisation d'un composant électromécanique suivant l'invention, pour un système électro-mécanique, va à présent être donné en liaison avec les figures 1A-1J (les figures 1A-1J représentant une vue en coupe du composant en cours de réalisation).

Par système électromécanique, on entend ici un microsystème électromécanique communément appelé « MEMS » ou un nano-système électromécanique (NEMS) intégrant sur une puce ou un substrat, au moins un composant électromécanique doté d'un ou plusieurs éléments ou organes ayant une taille à l'échelle micrométrique ou nanométrique.

On forme tout d'abord sur un support 100, une première couche 102, à base d'un matériau donné 103.

Le support 100 peut être un substrat, ou une couche supérieure d'un empilement de couches reposant sur un substrat. Le support 100 peut être par exemple une couche de substrat massif (communément appelé « bulk » selon la terminologie anglo-saxonne) à base Si, ou de substrat de type semi-conducteur sur isolant tel qu'un substrat de type SOI (SOI pour « Silicon On Insulator » ou silicium sur isolant), ou par exemple une couche de SiC sur Si « bulk », ou par exemple une couche de substrat SiC sur Oxyde (SiCOI).

Le matériau donné 103 peut être un matériau sur lequel, ou à partir duquel, du graphène peut être formé.

Le matériau donné 103 est un matériau choisi de manière à être compatible avec une croissance de feuillets de graphène, et/ou un matériau dont au moins une épaisseur peut être traitée, par exemple à l'aide d'un recuit, de manière à être décomposée et transformée en un empilement de plusieurs feuillets de graphène.

Le matériau donné 103 peut être par exemple du SiC ou du cuivre (Cu) ou du Nickel (Ni) ou de l'iridium (Ir) ou du platine (Pt) ou du ruthenium (Ru) ou du Palladium (Pd).

La première couche 102 peut avoir une épaisseur comprise par exemple entre plusieurs nanomètres et plusieurs dizaines de micromètres, par exemple comprise entre 100 nanomètres et 20 micromètres (figure 1A).

Ensuite, on forme un masquage 105 sur la première couche 102, par exemple par dépôt d'une couche de masquage par exemple à base de SiₓN_{y} ou de résine ou d'oxyde de silicium SiₓO_{y}, puis gravure de cette couche de masquage de manière à définir un ou plusieurs motifs du masquage (figure 1B).

On réalise ensuite dans la couche 102 de matériau 103 un ou plusieurs éléments d'un composant électromécanique, dont au moins un barreau 108 à base du matériau donné 103, ce barreau étant destiné à former un organe fixe du composant électromécanique, et en particulier à former un axe de rotation de ce composant.

Le barreau 108 s'étend dans une direction réalisant un angle non-nul, qui peut être de 90° ou proche de 90°, avec le plan principal du support 100, (le plan principal du support 100 étant défini comme un plan passant par ce dernier et qui est parallèle à un plan [O;*̅i̅*̅;*̅j̅*̅] d'un repère orthogonal [O;*̅i̅*̅;*̅j̅*̅;*̅k̅*̅] donné sur la figure 1C).

Le barreau 108 peut être formé avec une dimension critique dc, définie comme la plus petite dimension du barreau 108 et mesurée ici dans un plan parallèle au plan principal du support 100, peut être comprise entre une dizaine de nanomètres et plusieurs dizaines de micromètres, par exemple comprise entre 20 nanomètres et 100 nanomètres dans le cas où l'on réalise un nano-système, ou par exemple entre 1 micromètre et 10 micromètres dans le cas où l'on réalise un micro-système. La dimension critique dc peut être adaptée en fonction de l'application visée et de la masse que ce barreau 108 peut être destinée à porter.

Le barreau 108 peut être réalisé par gravure anisotrope de la première couche 102 à travers le masquage 105, par exemple à l'aide d'une lithographie à l'aide d'un faisceau d'électrons suivie d'une gravure plasma. Cette gravure peut être réalisée jusqu'à atteindre le support 100.

On retire ensuite le masquage 105.

On peut ensuite conférer un profil arrondi au barreau 108 ou bien arrondir le barreau 108, par exemple, lorsque ce dernier est à base de SiC, en effectuant une gravure sous H₂ ou un recuit sous atmosphère d'hydrogène à une température par exemple comprise entre 700°C et 1200°C.

Puis, on forme sur l'élément 108, un empilement de plusieurs couches, ou de n feuillets 110₁...110ₙ de graphène avec n ≥ 2. Les feuillets 110₁...110ₙ sont formés de sorte qu'au moins un premier feuillet 110₁, et au moins un deuxième feuillet 110₂ sur le premier feuillet 110₁, recouvrent le barreau 108 de matériau donné 103. Le nombre n de feuillets formés peut être par exemple compris entre 2 et 10, ou par exemple entre 2 et plusieurs dizaines, ou par exemple entre 2 et plusieurs centaines. Les feuillets 110₁...110ₙ de graphène peuvent être constitués chacun d'une monocouche d'atomes de carbone qui peut être de l'ordre de 3 Angströms d'épaisseur ou éventuellement de plusieurs monocouches d'atomes de carbone.

Les feuillets 110₁...110ₙ de graphène peuvent être formés par graphénisation d'un matériau déposé sur le matériau donné 103 ou par graphénisation d'une épaisseur du matériau donné 103.

Le matériau donné 103 peut être par exemple du SiC ou du cuivre (Cu) ou du Nickel (Ni) ou de l'iridium (Ir) ou du platine (Pt) ou du ruthenium (Ru) ou du Palladium (Pd).

La graphénisation, peut être par exemple une graphénisation de SiC effectuée par exemple de la manière décrite dans le document : « Ultrathin Epitaxial Graphite : 2D Electron Gas Properties and a Route toward Graphene-based Nanoelectronics », Berger et al., American Chemical Society 2004, ou dans le document : Forbeaux et al., Surf. Sci 442, 1999, ou dans le document US 7 015 142 B1.

Selon une autre possibilité, les feuillets 110₁...110ₙ de graphène peuvent être formés sur la couche de matériau donné 103, par croissance sur le matériau donné 103.

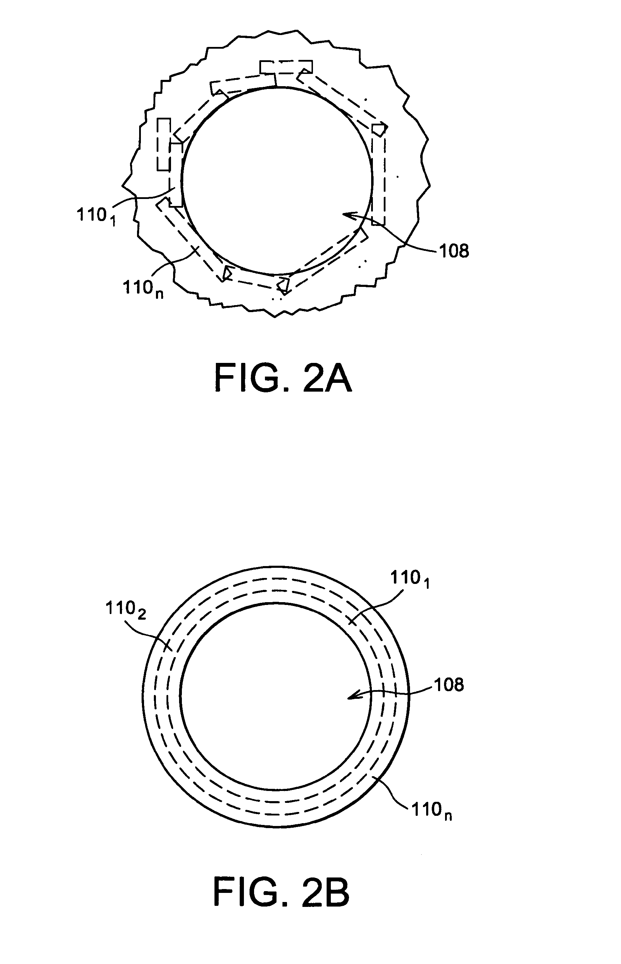

Les feuillets 110₁...110ₙ de graphène peuvent être respectivement sous forme d'un empilement de couches continues entourant le barreau 108 comme cela est représenté par exemple sur la figure 2B, ou sous forme d'un empilement de zones distinctes, réparties de manière discontinue autour du barreau 108 comme cela est représenté par exemple sur la figure 2A (les figures 2A et 2B donnant une vue en coupe du barreau 108 selon un plan de coupe parallèle au plan principal du support 100 dans le cas donné à titre d'exemple lorsque le barreau est de forme cylindrique).

On forme ainsi au moins un premier feuillet solidaire du barreau 108 et qui est lié à ce dernier, ainsi qu'au moins un deuxième feuillet, qui est disjoint du premier feuillet ou n'est pas lié au premier feuillet, et est susceptible d'être déplacé par rapport au barreau 108 et au premier feuillet. Le premier feuillet est ainsi destiné à former avec le barreau 108 un organe fixe du composant électromécanique, tandis que le deuxième feuillet est destiné à former une partie d'organe mobile du composant électromécanique.

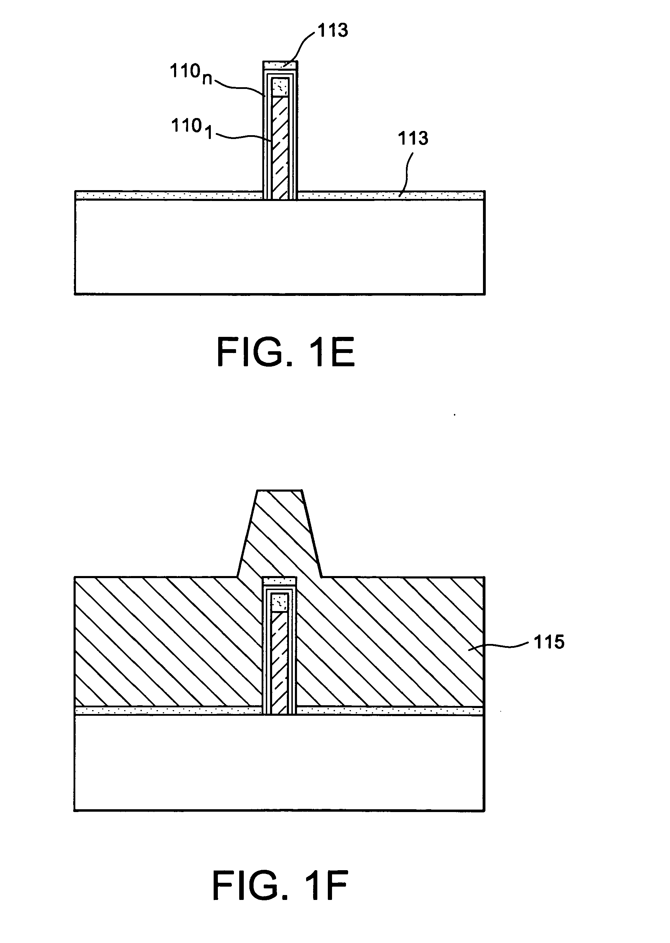

Ensuite (figure 1E), on forme une première couche de matériau sacrificiel 113 sur le support 100 et sur le barreau 108. Le matériau 113 peut être formé par un dépôt non-conforme, de sorte que le matériau 113 ne recouvre pas les flancs du barreau 108. L'épaisseur du matériau 113 déposé, peut être comprise par exemple entre plusieurs dizaines et plusieurs centaines de nanomètres. Le matériau sacrificiel 113 peut être un matériau choisi de manière à pouvoir être gravé de manière sélective vis-à-vis du matériau 103 du barreau 108 et des feuillets de graphène. Le matériau sacrificiel 113 peut être par exemple du SiO₂ en particulier dans le cas où le barreau 108 est à base de SiC (figure 1E).

On forme ensuite autour du barreau 108, et éventuellement sur le barreau 108, au moins une couche d'un matériau 115, dans lequel au moins élément d'un organe mobile du composant électromécanique est destiné à être réalisé. Le matériau 115 peut être par exemple un matériau métallique. Le matériau 115 peut être déposé sur le support 100 et sur l'élément 108, selon une épaisseur qui peut être comprise par exemple entre plusieurs dizaines et plusieurs centaines de nanomètres (figure 1F).

Une étape de polissage mécano-chimique (CMP) du matériau 115 avec arrêt au niveau du sommet barreau 108, en particulier jusqu'au niveau du sommet du barreau 108, peut être ensuite effectuée, par exemple dans un cas où le matériau 115 déposé dépasse de la hauteur du barreau 108.

Puis, on forme une deuxième couche de matériau sacrificiel 117 reposant sur le dessus du barreau 108 et sur la couche de matériau 115. La deuxième couche de matériau sacrificiel 117 peut avoir une épaisseur qui peut être comprise par exemple entre plusieurs dizaines de nanomètres et plusieurs centaines de nanomètres. Le matériau sacrificiel 117 peut être choisi de manière à pouvoir être gravé de manière sélective vis-à-vis du barreau 108, des feuillets de graphène, ainsi que du matériau 115 dans lequel l'organe mobile est destiné à être formé. Le matériau sacrificiel 117 peut être par exemple du SiO₂.

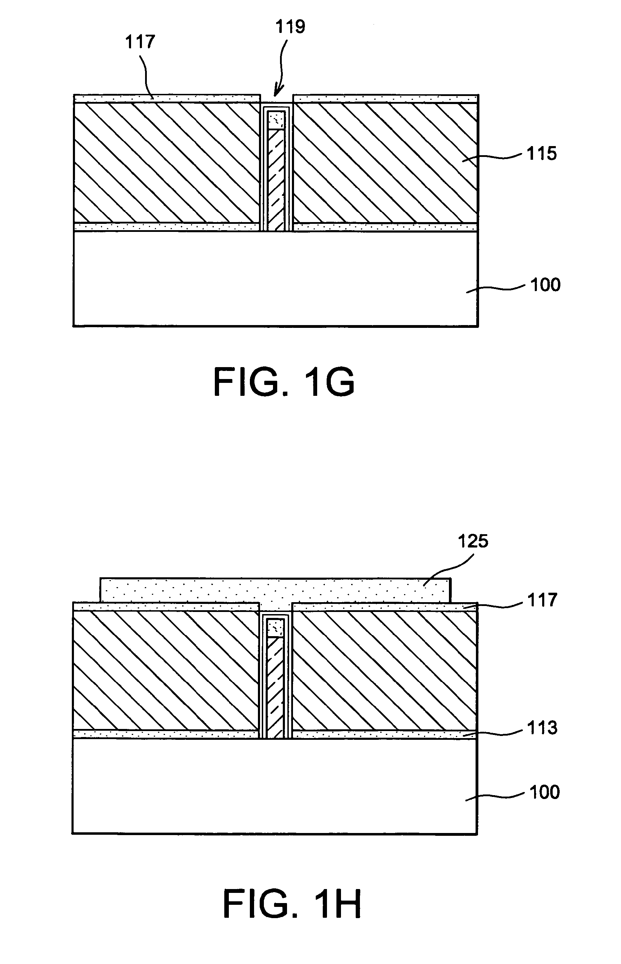

On forme ensuite une ouverture 119 dans la couche de matériau sacrificiel 117, de manière à dévoiler le sommet du barreau 108. L'ouverture 119, peut être réalisée à l'aide d'étapes de photolithographie, et de gravure de la deuxième couche de matériau sacrificiel 117 (figure 1G).

Puis, on forme une couche de matériau 125 dans laquelle un élément de protection du composant, qui peut être sous forme d'un capot, est destiné à être réalisé. Le matériau 125 dans lequel sera formé le capot, peut être choisi de sorte que les matériaux 113 et 117 des couches sacrificielles peuvent être gravés de manière sélective par rapport à ce matériau 125. Le matériau 125 peut être par exemple du SiₓN_{y}, en particulier dans le cas où les couches de matériaux sacrificiels 113 et 117, sont à base de SiO₂.

On forme ensuite au moins un motif dans la couche de matériau 125, de manière à définir le capot. Cela peut être réalisé par exemple par des étapes de photolithographie, puis de gravure anisotrope de la couche de matériau 125 (figure 1H).

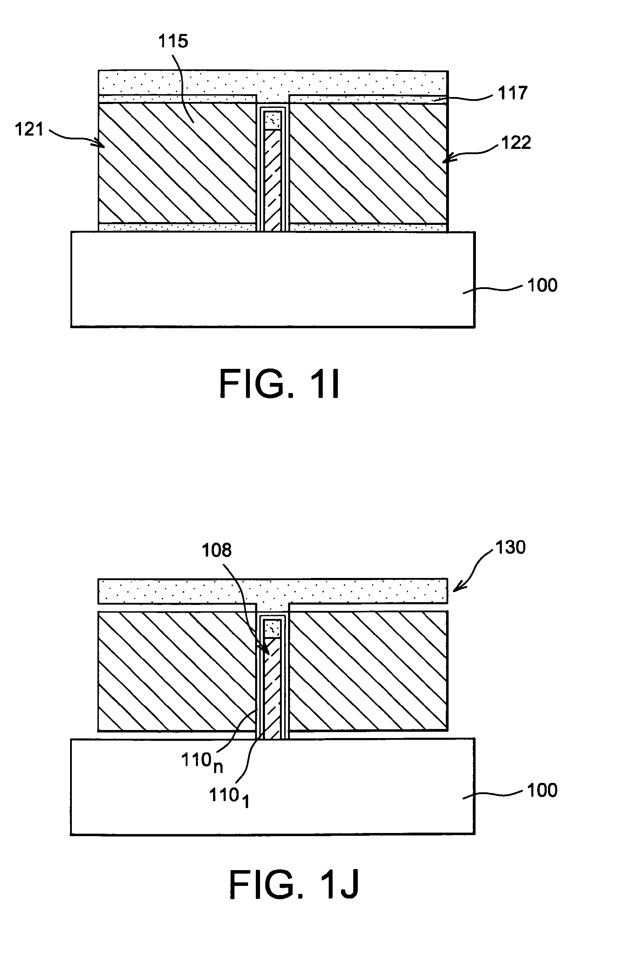

Ensuite, on défini l'élément mobile, par exemple sous forme d'ailettes 121, 122, dans la couche de matériau 115. Pour cela on peut effectuer une gravure anisotrope de la deuxième couche de matériau sacrificiel 117, du matériau 115, de la couche de matériau sacrificiel 113 (figure 1I).

Puis, on supprime les couches sacrificielles 113 et 117, par exemple à l'aide de HF vapeur. On libère ainsi l'organe mobile du composant électromécanique, par exemple sous forme d'ailettes 121, 122, du support 100, et on sépare ainsi le capot 130 des ailettes 121 et 122 (figure 1J).

Des moyens d'actionnement de l'organe mobile (non représentés), par exemple des moyens d'actionnement électrostatiques comportant une ou plusieurs électrodes d'actionnement, ou des moyens d'actionnement électromagnétiques peuvent être ensuite réalisés.

Ainsi, dans ce premier exemple de procédé on a réalisé un composant électromécanique doté d'un organe fixe sous forme d'un barreau 108 formant un axe de rotation, à base du matériau 103 recouvert d'un ou plusieurs premier(s) feuillet(s) de graphène liés au matériau 103 du barreau 108. Le composant électromécanique est également doté d'un organe mobile en rotation autour du barreau 108. L'organe mobile comporte un ou plusieurs deuxième(s) feuillet(s) de graphène qui ne sont pas liés au matériau 102 du barreau 108 et aux premiers feuillets et qui sont susceptibles de se déplacer autour du barreau 108.

Les deuxième(s) feuillet(s) de graphène sont solidaires des ailettes 121, 122 et destinés à tourner autour d'au moins une portion barreau 108. Un capot 130 de retenue est prévu au sommet du barreau 108, et peut avoir pour rôle, celui de permettre d'empêcher un détachement des ailettes 121, 122 ainsi qu'un rôle de protection.

Certains feuillets peuvent être liés entre eux par exemple notamment par des liaisons de type Van de Waals. Pour permettre d'obtenir un libre mouvement des deuxièmes feuillets par rapport aux premiers feuillets, on peut rompre ces liaisons par exemple en actionnant l'organe mobile du composant. Une mise en mouvement de l'organe mobile, peut permettre de rompre ou de supprimer les liaisons entre le ou les feuillets de graphène lié(s) au barreau 108 et le ou les feuillets de graphène de l'organe mobile, qui sont solidaires des ailettes. On peut obtenir ainsi une libre rotation de l'organe mobile autour du barreau formant l'axe de rotation.

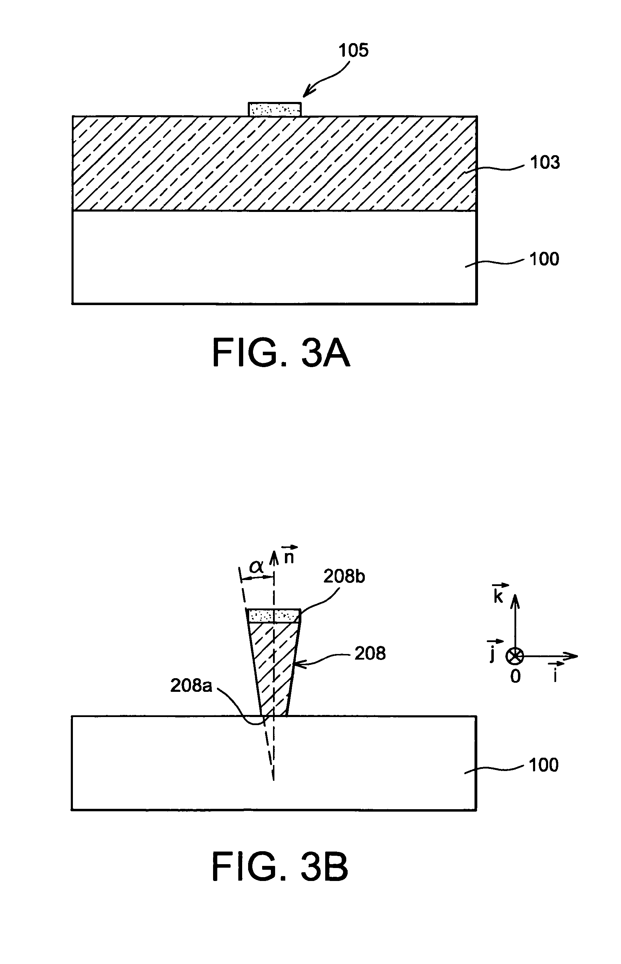

Une variante de l'exemple de procédé de réalisation décrit précédemment, va être donnée en liaison avec les figures 3A-3G (les figures 3A-3G représentant une vue en coupe du composant en cours de réalisation, seuls les éléments situés dans le plan de coupe étant représentés sur ces figures).

On forme tout d'abord sur le support 100, la première couche 102, à base du matériau donné 103 (figure 3A), dans laquelle on forme un barreau 208 à base du matériau donné 103 destiné à former un axe de rotation du composant. Dans cet exemple, le barreau 208 réalisé est perpendiculaire avec le plan principal du support 100, et comporte une forme évasée avec une base 208a reposant sur le support 100, moins large que son sommet 208b. Le barreau 208 peut être formé avec des flancs formant un angle α, incliné par rapport à une normale *̅n̅*̅ au plan principal du support 100.

Le barreau 208, peut être réalisé par gravure de la première couche 102 à travers un masquage 105. Cette gravure peut être réalisée jusqu'à atteindre le support 100.

On retire ensuite le masquage 105 (figure 3B). Puis, on peut conférer au barreau 208 un profil arrondi, par exemple en effectuant un recuit sous atmosphère d'hydrogène à une température par exemple comprise entre 850°C et 900°C.

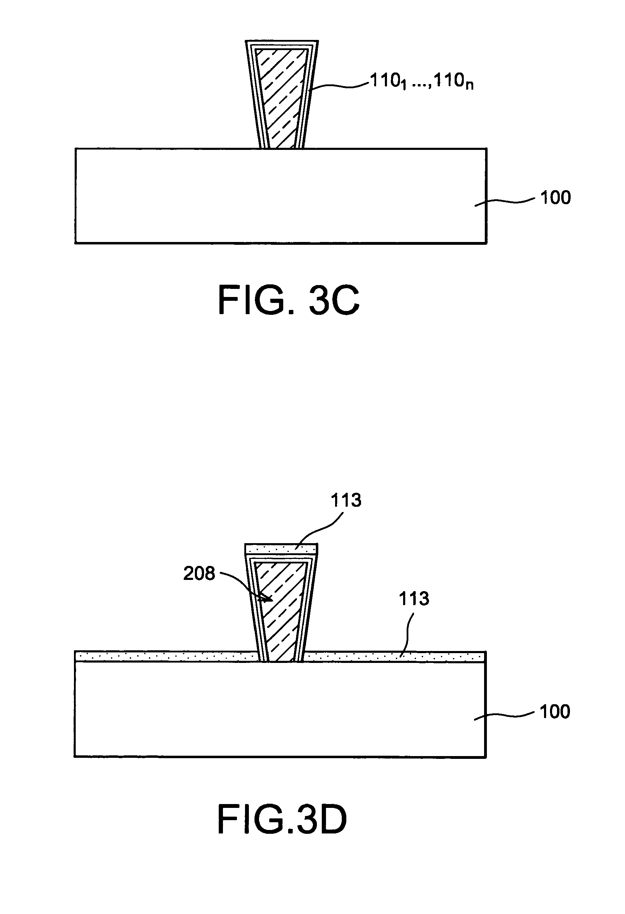

On effectue ensuite l'étape de graphénisation du barreau 208 (figure 3C) ou de croissance dans laquelle, on forme sur ou à partir du barreau 208, un empilement de plusieurs feuillets 110₁...110ₙ de graphène, avec au moins un feuillet de graphène solidaire du barreau 208, et au moins un deuxième feuillet disjoint du premier feuillet de graphène et susceptible d'être déplacé par rapport au premier feuillet.

Le barreau 208 à forme évasée peut être ainsi recouvert de graphène.

On forme ensuite la première couche de matériau sacrificiel 113, par exemple à base de SiO₂, sur le support 100 et sur le barreau 208, par exemple par un dépôt qui n'est pas conforme, et qui est réalisé de manière à recouvrir le sommet du barreau 208 et le support 100, sans recouvrir les flancs du barreau 208 (figure 3D).

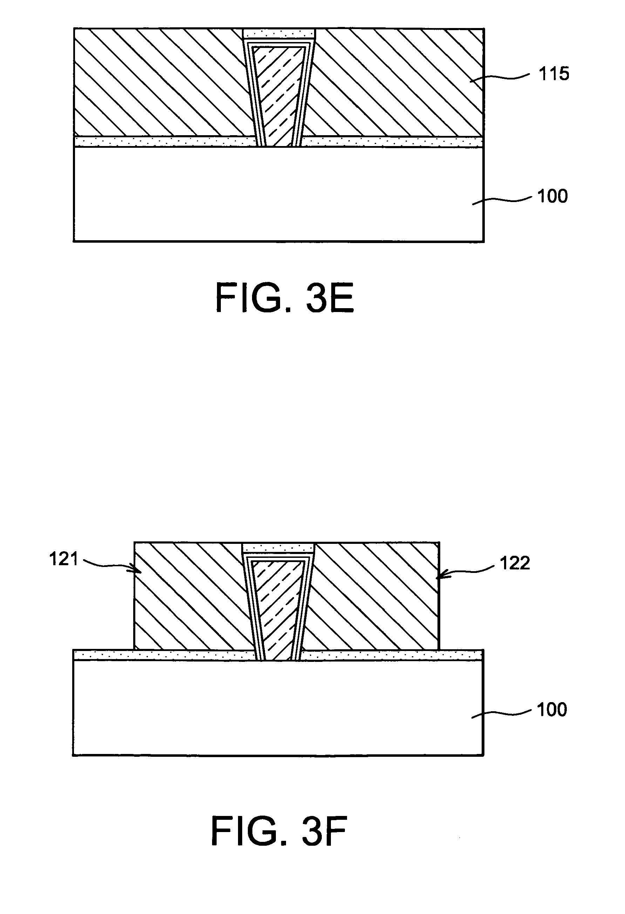

On dépose ensuite autour du barreau 208 le matériau 115 dans lequel au moins un élément d'organe mobile du composant est destiné à être formé (figure 3E). Dans le cas où le matériau 115 recouvre le barreau 208, une étape de polissage du matériau 115 peut être prévue.

Puis, on forme l'élément d'organe mobile, par exemple des ailettes 121, 122 par gravure du matériau 115 (figure 3F).

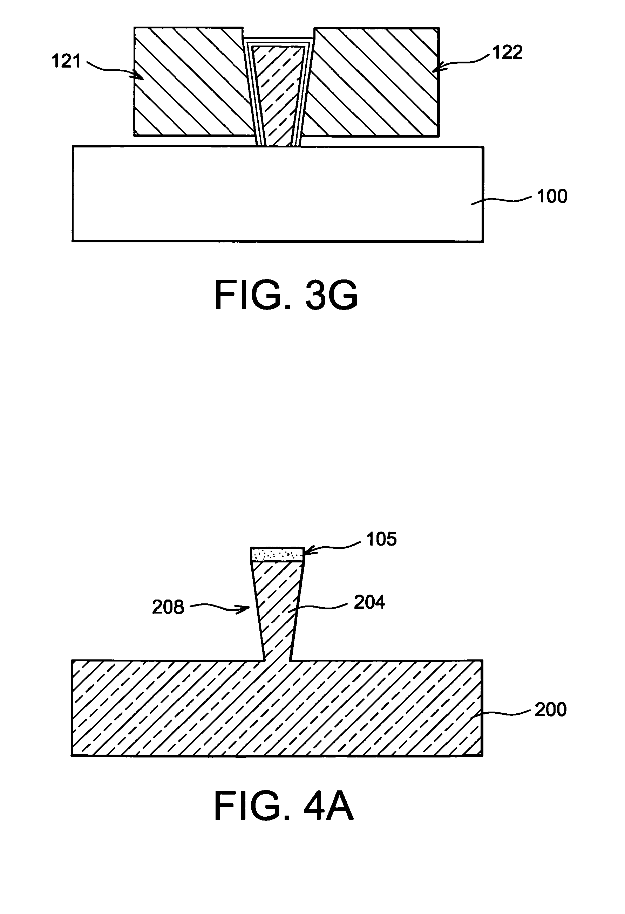

On supprime ensuite le matériau sacrificiel 113 se trouvant au sommet du barreau 208, ainsi que sur le support 100, de manière à libérer les ailettes 121, 122 du support 100 (figure 3G).

Une variante de l'exemple de procédé de réalisation décrit précédemment, va être donnée en liaison avec les figures 4A-4C (les figures 4A-4C représentant une vue en coupe du composant électro-mécanique en cours de réalisation, seuls les éléments situés dans le plan de coupe étant représentés).

On forme tout d'abord sur un support 200, une première couche, à base d'un matériau 204, qui peut être un choisi notamment de manière à pouvoir être modelé aisément et qui peut permettre de former un structure rigide, par exemple un matériau semi-conducteur tel que du Si (figure 4A).

Dans la première couche 202, on forme ensuite un barreau 208 à forme évasée à base du matériau 204 destiné à former un axe de rotation du composant. Le barreau 208 réalisé est perpendiculaire avec le plan principal du support 200, et comporte, comme dans l'exemple précédent, une forme évasée avec une base reposant sur le support 200, moins large que son sommet.

Le barreau 208, peut être réalisé par gravure de la première couche 204 à travers un masquage 105, par exemple à l'aide d'un plasma HCl/Br₂/O₂ ou SF₆/O₂. Le masquage 105 est ensuite retiré.

On peut ensuite donner au barreau 208 un pourtour arrondi, par exemple en effectuant un recuit sous atmosphère d'hydrogène à une température élevée, par exemple comprise entre 850°C et 900°C.

Ensuite, on forme sur le barreau 208, un matériau donné 209 choisi de manière à être compatible avec une croissance de graphène ou à partir duquel du graphène peut être formé. Ainsi, le matériau donné 209 est un matériau sur lequel ou à partir duquel une ou plusieurs couches, ou feuillets, de graphène, peuvent être formé(e)s. Le matériau donné 209 peut être par exemple du carbone amorphe.

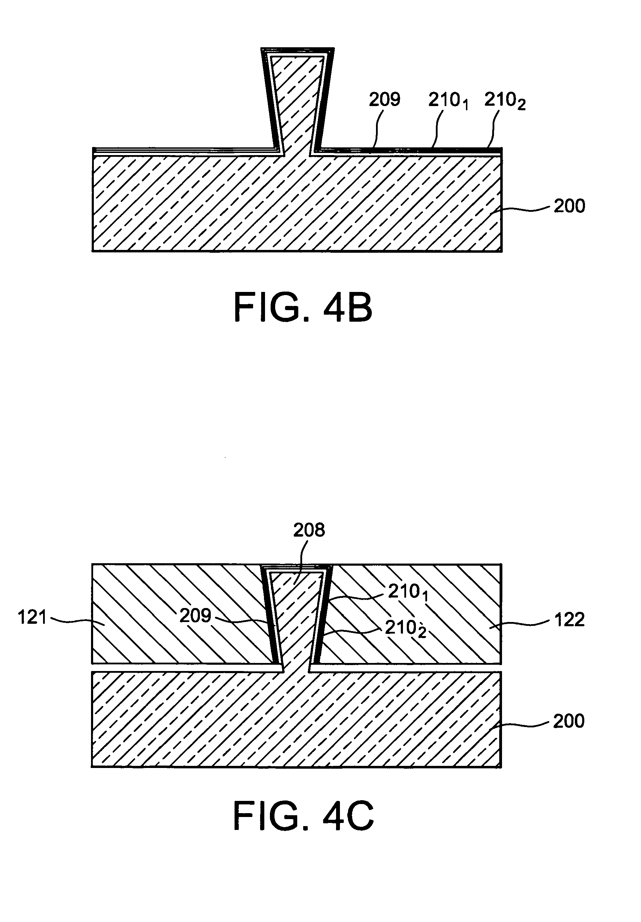

Ensuite, on forme sur le matériau donné 209 ou à partir du matériau donné 209, un empilement de plusieurs couches, ou de feuillets 210₁, 210₂ de graphène, par exemple d'une manière telle que décrite dans le document : « Rapid Thermal annealing of amorphous hydrogeneted carbon films », Alterovitz et al., meeting of the materials research society, 1987, ou le document Yaduda et al., Phys. Stat. Sol. 1986, ou le document « Electrical conductivity of as prepared and annealed amorphous hydrogenated carbon films », Reyes-Mena et al., Journal of Vacuum Science Technology, May June 1990 (figure 4B).

On dépose ensuite autour du barreau 208 le matériau 115 dans lequel l'élément d'organe mobile, par exemple des ailettes, est destiné à être formé. Puis, on forme cet élément, par exemple ces ailettes 121, 122, par gravure du matériau 115.

On effectue ensuite une gravure sélective du matériau donné 209 et du graphène vis-à-vis du matériau 115.

Une telle gravure est réalisée afin de supprimer les zones de matériau donné 209 et de graphène qui recouvrent la surface du support 200, et de libérer les ailettes 121, 122 (figure 4C).

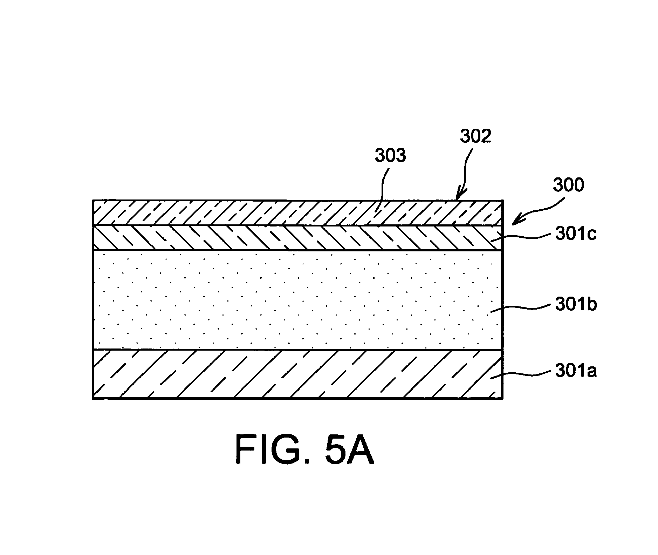

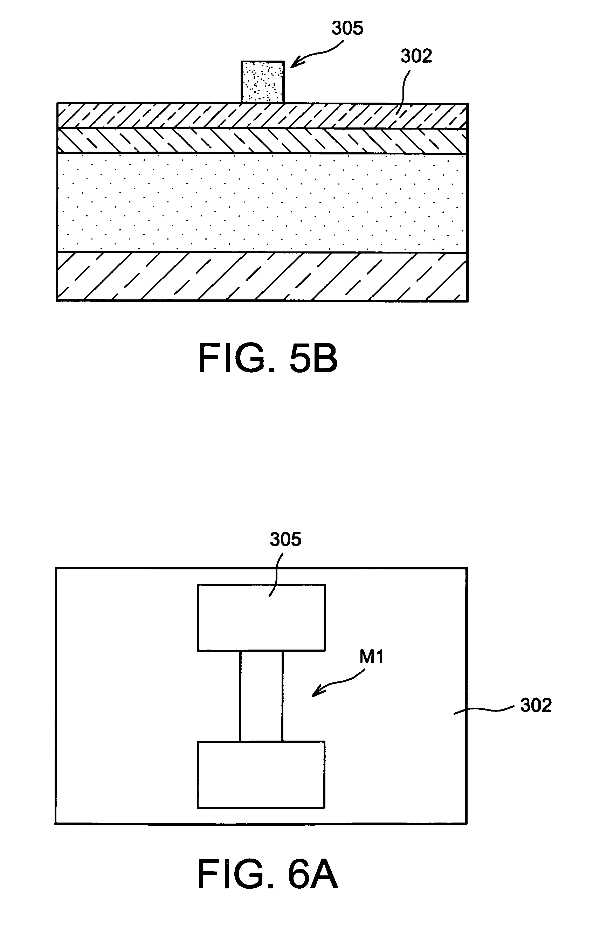

Un exemple de procédé de réalisation d'un composant électro-mécanique suivant l'invention, va à présent être donné en liaison avec les figures 5A-5I et 6A-6H (les figures 5A-5I représentant une vue en coupe transversale, tandis que les figures 6A-6H représentent une vue de dessus, du composant en cours de réalisation).

On forme tout d'abord sur un support 300, une première couche 302 à base d'un matériau donné 303, choisi de sorte qu'au moins une partie de son épaisseur, peut être décomposée et transformée en une pluralité de feuillets de graphène, ou choisi de sorte qu'il peut servir de support de croissance à du graphène. Le matériau donné 303 peut être par exemple du SiC monocristallin ou polycristallin.

La première couche 302 peut avoir une épaisseur par exemple comprise entre plusieurs nanomètres et plusieurs centaines de nanomètres, par exemple entre 10 et 500 nm.

Le support 300 peut comprendre une couche supérieure 301c d'un substrat ou d'un empilement de couches reposant sur un substrat, sur laquelle la première couche 302 est réalisée.

La couche supérieure 301c est à base d'un matériau choisi de sorte que la première couche 302 de matériau donné 303 peut être gravée de manière sélective vis-à-vis de la couche supérieure 301c. La couche supérieure 301c peut être à base d'un matériau semi-conducteur, par exemple tel que du Si. La couche supérieure 301c peut avoir une épaisseur comprise par exemple entre une dizaine de nanomètres et une centaine de micromètres.

Dans cet exemple, la couche supérieure 301c repose sur une couche intermédiaire 301b qui peut être isolante, par exemple à base de SiO₂, et d'épaisseur de l'ordre d'une centaine de nanomètres. La couche supérieure 301c est de préférence également prévue de manière à pouvoir être gravée sélectivement par rapport à la couche 301b intermédiaire.

La couche intermédiaire 301b repose quant à elle sur une couche de support 301a, et peut être gravée sélectivement par rapport à la couche de support 301a. Cette couche de support 301a peut être semiconductrice, par exemple à base de Si (figure 5A).

Un masquage 305, par exemple en résine ou par exemple à base d'un métal tel que de l'aluminium afin de résister à une étape de gravure de la première couche 302, est ensuite formé sur la première couche 302. Le masquage 305 peut comporter un motif par exemple tel que celui M₁ donné en figure 6A comportant une zone de forme sensiblement rectangulaire reliant deux zones rectangulaires de largeur plus importante (figures 5B et 6A).

On réalise ensuite, dans la couche de matériau donné 303, un barreau 308 destiné à former un axe de rotation du composant électromécanique. Le barreau 308 est réalisé par gravure de la première couche 302, par exemple par gravure plasma telle qu'une gravure RIE (RIE pour « Reactive Ion Etching ») ou haute densité à l'aide par exemple de CHF₃/O₂, en particulier la gravure sélective réalisée est une gravure du SiC par rapport au Si.

Par gravure à travers le masquage 305, on peut former dans le même temps que le barreau, deux zones Z1, Z2 de formes sensiblement rectangulaires reliées par le barreau 308.

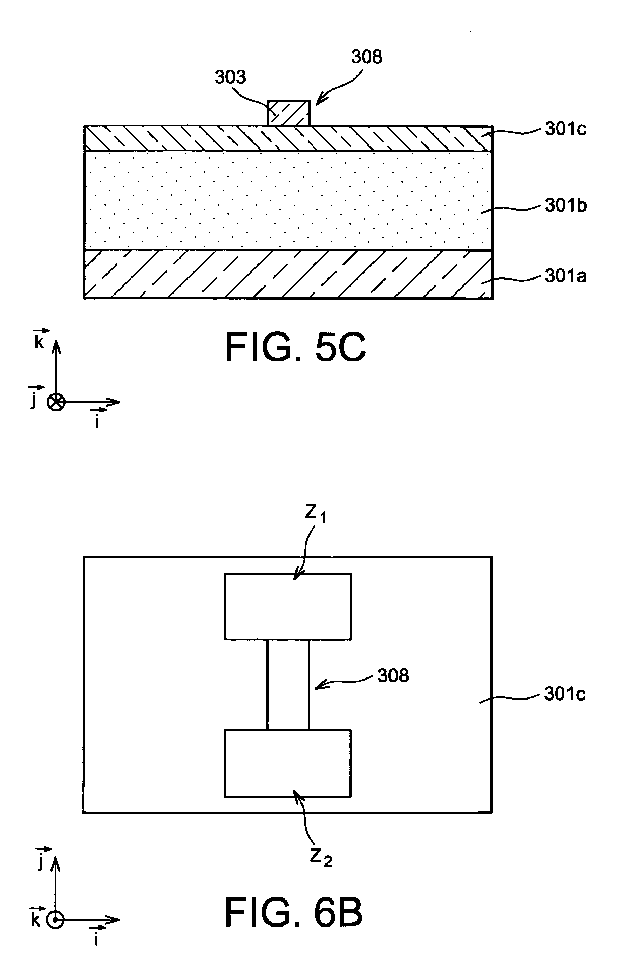

Le barreau 308 réalisé s'étend dans une direction parallèle avec le plan principal du support 300, c'est-à-dire un plan passant par le support 300 et parallèle à un plan [O;*̅i̅*̅;*̅j̅*̅] d'un repère orthogonal [O;*̅i̅*̅;*̅j̅*̅;*̅k̅*̅] défini sur les figures 5C et 6B.

Le barreau 308 peut être formé avec une dimension critique dc comprise par exemple entre plusieurs dizaines de nanomètres et plusieurs centaines de nanomètres, ou comprise entre 10 nanomètres et 10 micromètres. La dimension critique dc est définie comme la plus petite dimension du barreau 308 mesurée ici dans une direction parallèle au plan principal du support 300. Cette dimension critique peut être adaptée en fonction de l'application visée et de la masse que ce barreau 108 peut être destinée à porter.

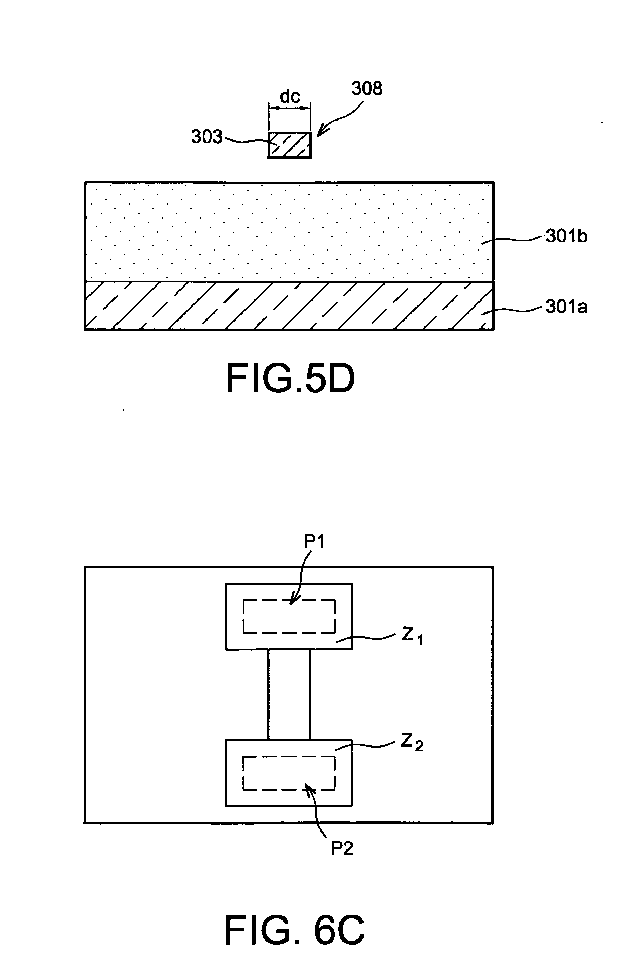

Ensuite, on effectue un retrait sélectif de la couche supérieure 301c, vis-à-vis du matériau donné 303 et de la couche intermédiaire 301b, par exemple par gravure isotrope, telle qu'une gravure humide à l'aide de KOH ou de TMAH. Des portions P1 et P2 (délimitées par des traits discontinus sur les figures 5D et 6C) de la couche supérieure 301b, sont conservées respectivement sous les zones Z1 et Z2 de la première couche 302, de manière à assurer une tenue mécanique de l'empilement.

Ensuite, on effectue une ou plusieurs étapes pour conférer au barreau 308 un profil arrondi. Cela peut être réalisé par exemple à l'aide d'un procédé de gravure, par exemple sous hydrogène, et/ou d'un traitement thermique par exemple par chauffage à une température compris entre 700°C et 1200°C.

Puis, on effectue une étape de formation de graphène sur le barreau 308, sous forme d'un empilement de plusieurs feuillets 110₁...110ₙ.

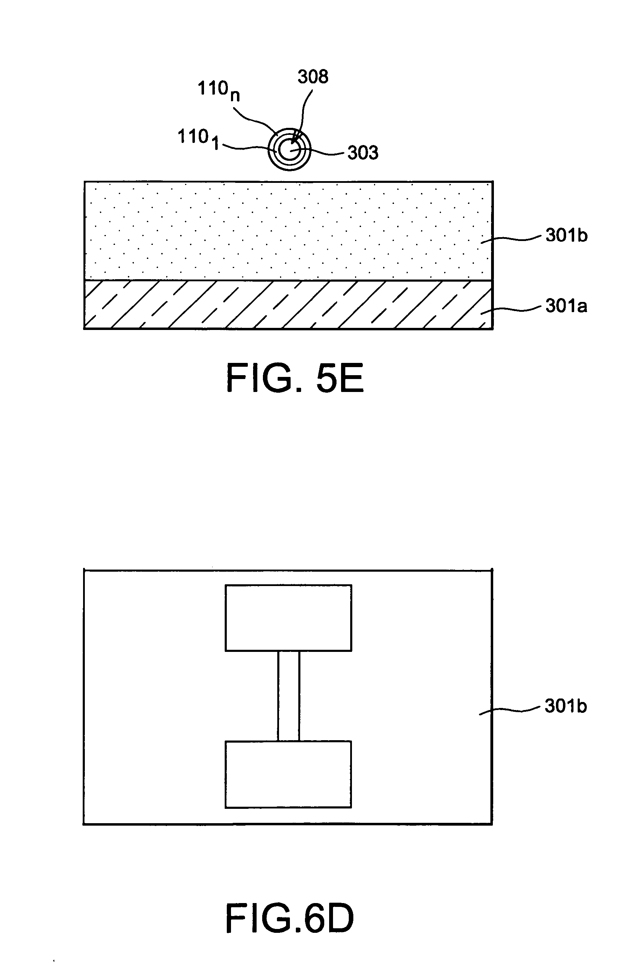

Cela peut être réalisé par dépôt ou par croissance de graphène sur le matériau donné 303 (figure 5E et 6D).

Un empilement de n feuillets 110₁...110ₙ de graphène, avec n par exemple compris entre 2 et 100, d'épaisseur comprise entre 0.6 et 40 nanomètres peut être réalisé.

Au moins deux des feuillets graphène de l'empilement sont séparés, de sorte qu'au moins un feuillet est solidaire du barreau et fixe et au moins un deuxième feuillet est mobile par rapport au barreau 308.

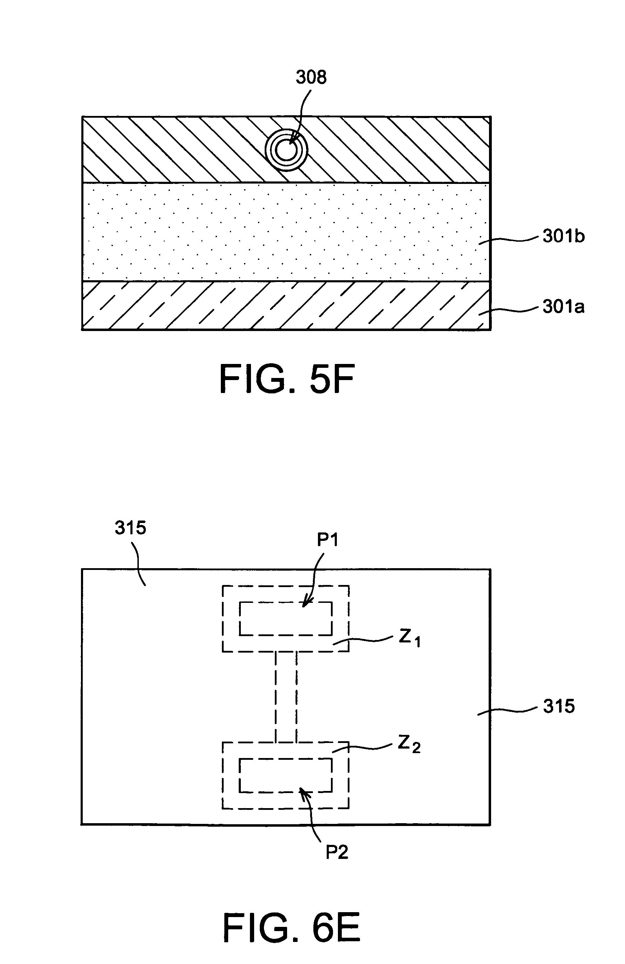

On forme ensuite autour du barreau 308 une couche d'un matériau 315 dans lequel un élément 321 d'organe mobile du composant, est destiné à être réalisé. Le matériau 315 peut être par exemple un matériau métallique tel que de l'Al, du TiN, ou du Ti, que l'on dépose par exemple par CVD (CVD pour « Chemical vapor deposition ») ou PECVD (PECVD pour « Plasma Enhanced Chemical vapor deposition ») sur la couche intermédiaire 301b support 300 (figure 5F et 6E).

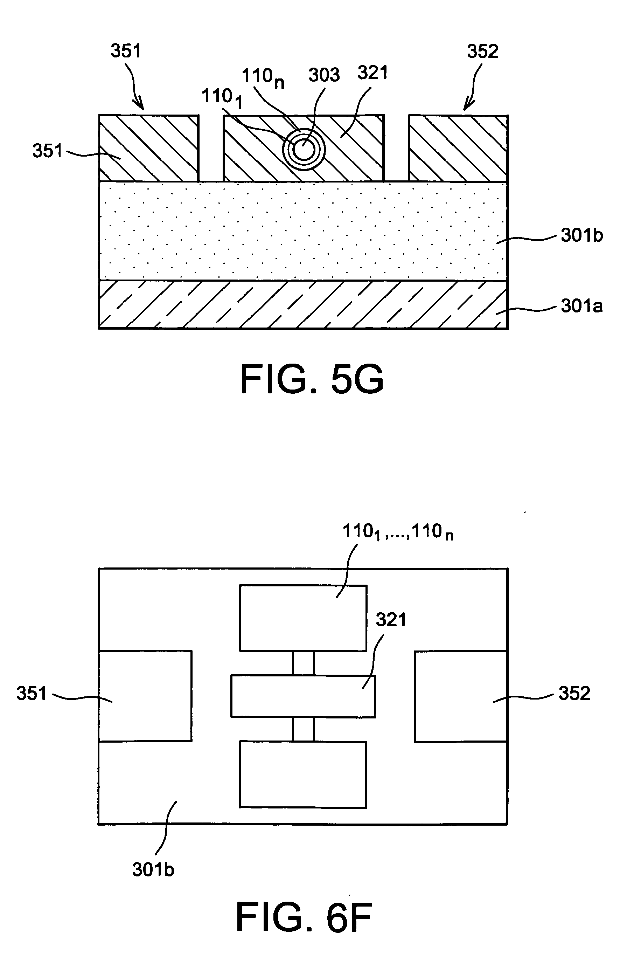

Ensuite, on forme dans le matériau 315, l'élément 321 d'organe mobile du composant. Lorsque le matériau 315 est un matériau métallique, des électrodes 351, 352 d'actionnement de l'organe mobile peuvent être également réalisés dans le matériau 315, en même temps que l'élément 321 (figure 5G et figure 6F). Cela peut être réalisé par photolithographie, puis gravure du matériau 315, par exemple par gravure plasma à l'aide d'un élément chloré tel que du Cl₂, du BCl₃, en particulier lorsque le matériau 315 est de l'aluminium.

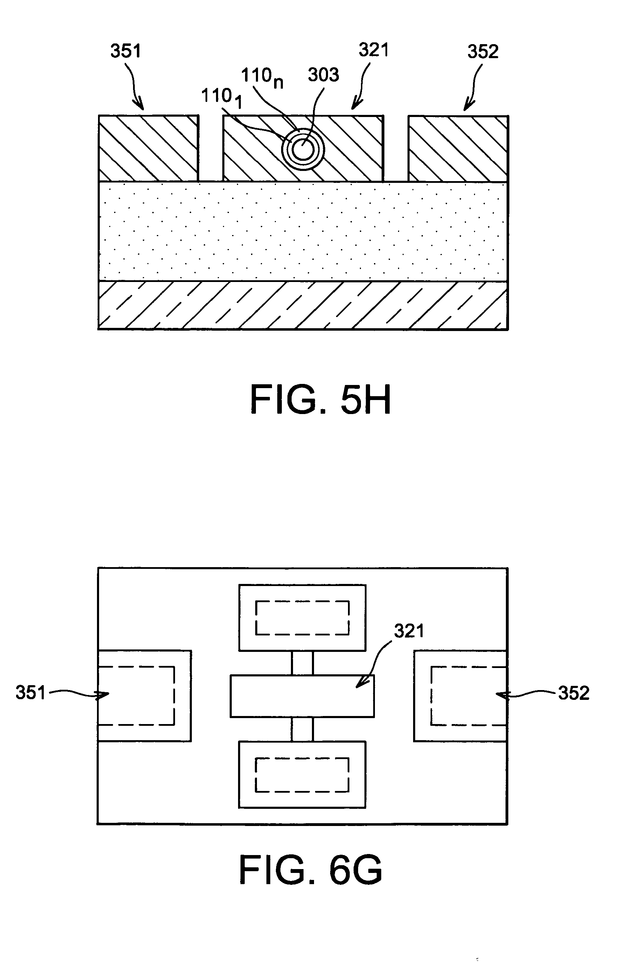

Ensuite, on effectue un retrait du graphène dans des zones de la structure qui ne sont pas recouvertes par le matériau 315 (figure 5H et figure 6G). Ce retrait peut être réalisé par une gravure, qui peut être sélective vis-à-vis de la couche intermédiaire 301b, du matériau donné 303 et du matériau 315. Une gravure à l'aide d'un plasma O₂ peut être par exemple mise en oeuvre pour effectuer ce retrait.

Puis, on libère l'élément 321, en gravant la couche intermédiaire 301b à travers les motifs réalisés dans le matériau 315 et de la couche supérieure 301b. Cela peut être réalisé à l'aide d'une gravure isotrope, par exemple une gravure à l'aide de HF liquide ou de HF vapeur.

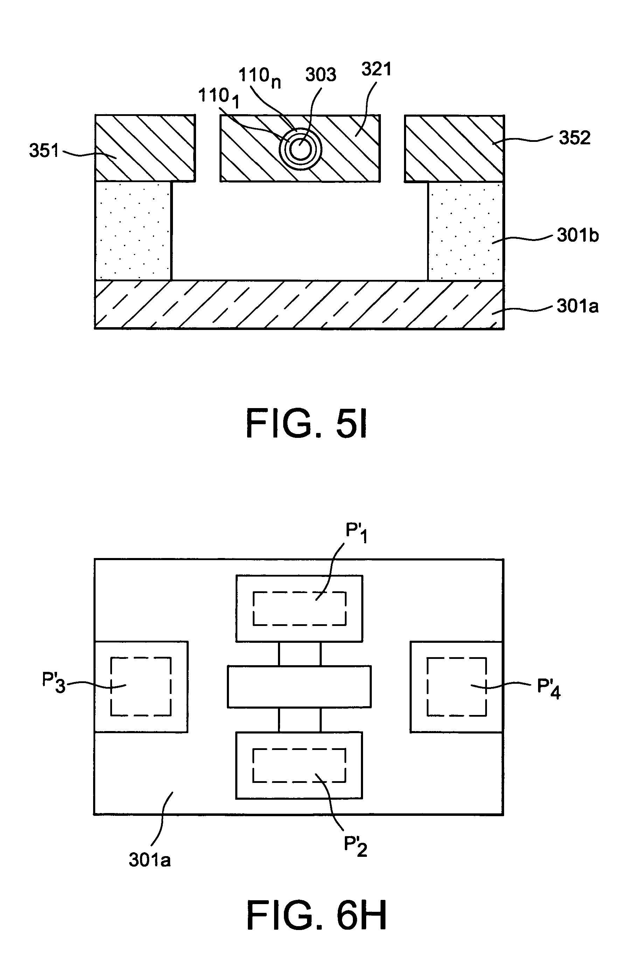

Le retrait peut être réalisé de sorte que des portions P'1, P'2, (délimitées par des traits discontinus sur les figures 5I et 6H) de la couche intermédiaire 301b, sont conservées sous les portions P1 et P2 de la couche supérieure 301a, des portions P'3, P'4 de la couche intermédiaire 301b, sont conservées sous les électrodes 351, 352, afin d'assurer une tenue mécanique de l'empilement.

Le retrait d'une portion de la couche intermédiaire 301b peut être réalisé de manière à permettre à l'élément 321 d'organe mobile de tourner tout autour du barreau 308.

Dans l'exemple de réalisation qui vient d'être donné, le barreau 308 réalisé, est rattaché à des zones Z1, Z2, de blocs d'ancrage qui sont formées à partir d'une même couche que ce barreau 308, dans un même matériau, ce qui permet de conférer à la structure une solidité accrue, en particulier au niveau des extrémités du barreau 308.

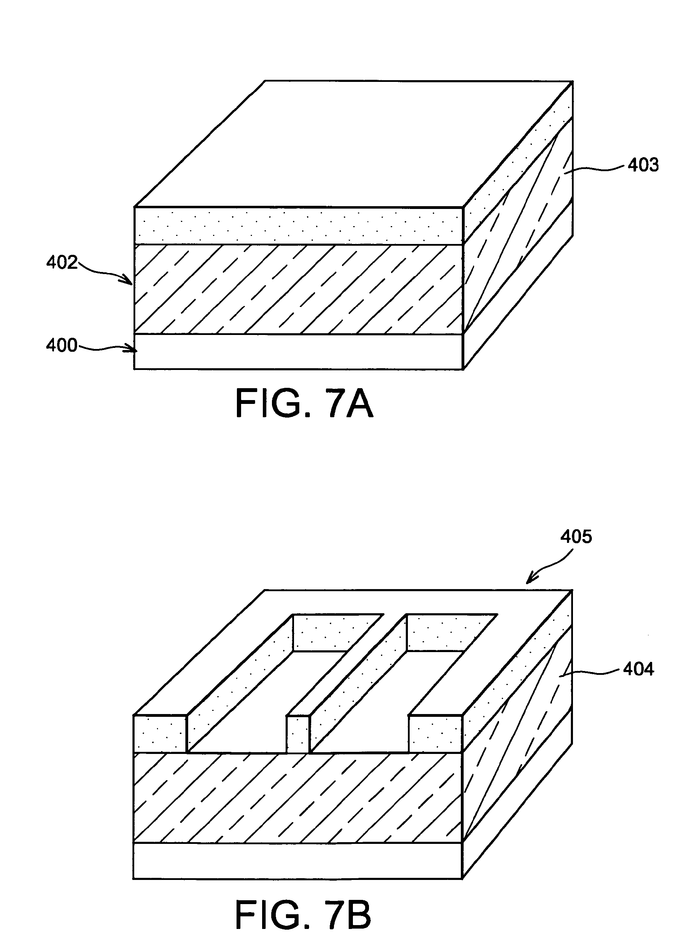

Une variante de l'exemple de procédé de réalisation qui vient d'être décrit, va être donnée en liaison avec les figures 7A-7L.

Sur un support 400 recouvert d'une première couche 402, à base d'un matériau 403 qui peut être semi-conducteur, par exemple tel que du Si, on forme une couche de masquage, par exemple à base de SiₓN_{y}, (figure 7A).

Puis dans cette couche de masquage, un masquage 405 est formé, par exemple à l'aide d'étapes de photolithographie et de gravure est réalisé. (figure 7B).

On forme ensuite un barreau 408 parallélépipédique dans la couche 402, par exemple par gravure anisotrope à travers le masquage 405.

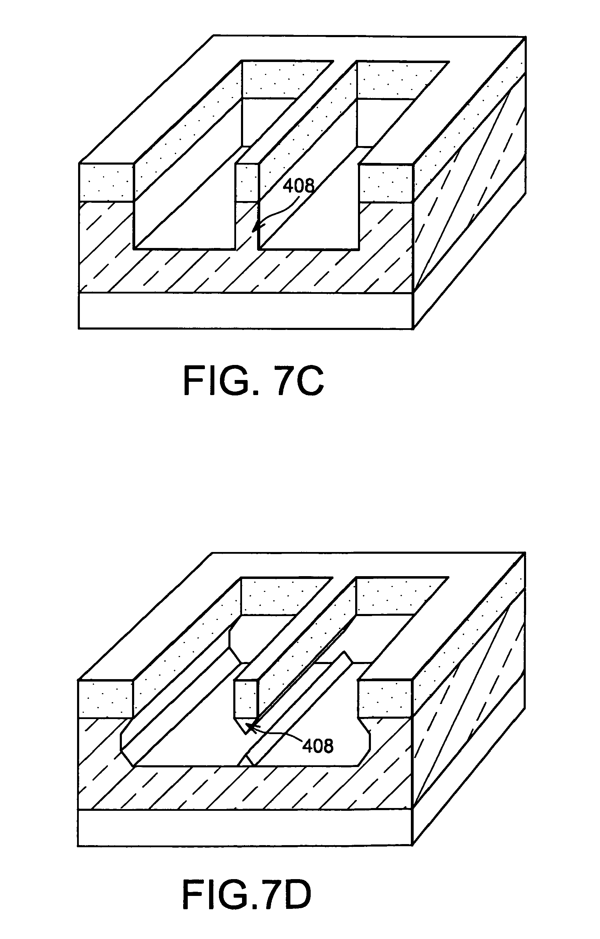

Une portion de la couche 402 de silicium est ainsi retirée, par exemple à l'aide d'un plasma. Le barreau 408 formé est situé dans une cavité 411 et est rattaché à au moins un bloc d'ancrage formé dans la même couche 402 du même matériau 403 que le barreau 408 (figure 7C).

Ensuite, on effectue une nouvelle gravure, par exemple une gravure isotrope du matériau 404 à travers le masquage 405, de manière à libérer le barreau 408 du support sur lequel il reposait, le barreau étant maintenu en suspension dans la cavité 411 par ledit bloc d'ancrage formé dans la couche 402 de matériau 404. La gravure isotrope peut être réalisée à l'aide de TMAOH (Tetramethylamoniumhydroxyde), ce qui peut conférer une forme biseautée au barreau 408 lorsque ce dernier est à base de Si (figure 7D).

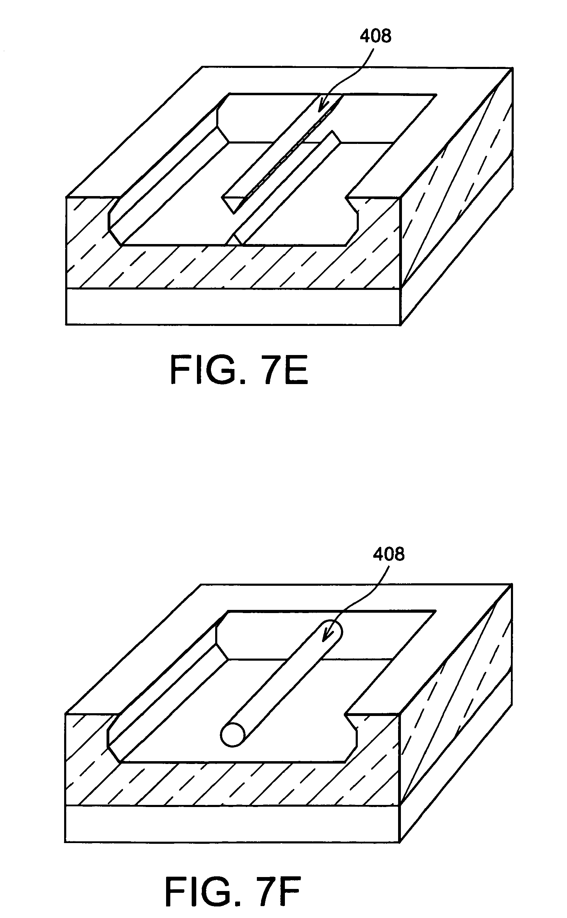

Puis (figure 7E), le masquage 405 est retiré, par exemple à l'aide de H₃PO₄.

Ensuite, on confère au barreau 408 un profil arrondi (figure 7F), par exemple en effectuant un recuit sous atmosphère d'hydrogène à une température par exemple comprise entre 850°C et 900°C.

Ensuite, on forme un matériau donné 409 sur lequel, ou à partir duquel, du graphène, peut être formé sous forme de plusieurs feuillets 410₁...410ₙ. Le matériau donné 409 peut être par exemple du carbone amorphe dans le cas où le graphène est formé à partir du matériau 409, ou du SiC.

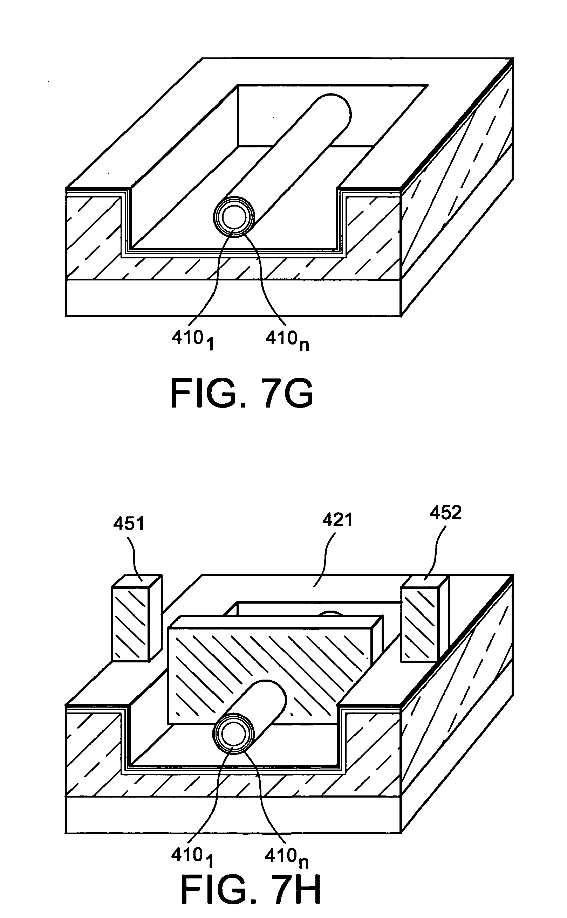

Ensuite, on forme sur le matériau donné 409 ou à partir du matériau donné 409, un des feuillets 410₁...410ₙ de graphène empilés, qui seront séparés de manière à conserver au moins un feuillet de graphène solidaire du barreau 408, et au moins un deuxième feuillet disjoint du premier feuillet de graphène, et susceptible de se déplacer par rapport au premier feuillet (figure 7G).

On dépose ensuite autour du barreau 408 un matériau 415, qui peut être métallique, et dans lequel on forme des électrodes 451, 452 d'actionnement, ainsi qu'un élément 421 destiné à former un organe mobile en rotation autour du barreau 408 et à être actionné par les électrodes 451, 452 (figure 7H).

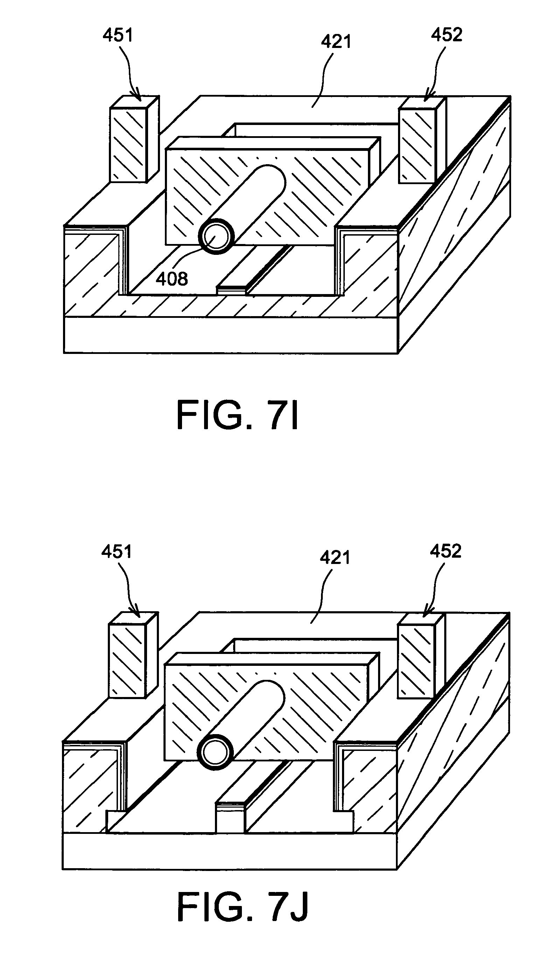

On effectue ensuite une gravure anisotrope du graphène au fond de la cavité 411, les autres zones sur lequel le graphène a été déposé étant protégées (figure 7I).

Cette étape peut être réalisée à travers un masque de résine (non représenté) qui peut avoir le même motif que celui du masquage 405 formé lors d'une étape ultérieure du procédé.

On retire ensuite une épaisseur de la couche sur laquelle repose l'élément 421, par exemple par gravure de la couche 404 de silicium (figure 7J).

L'épaisseur retirée dépend du mouvement que l'élément 421 du composant électro-mécanique est destiné à effectuer, et peut être prévue de sorte que cet élément 421 puisse tourner tout autour de la circonférence ou du pourtour du barreau 408.

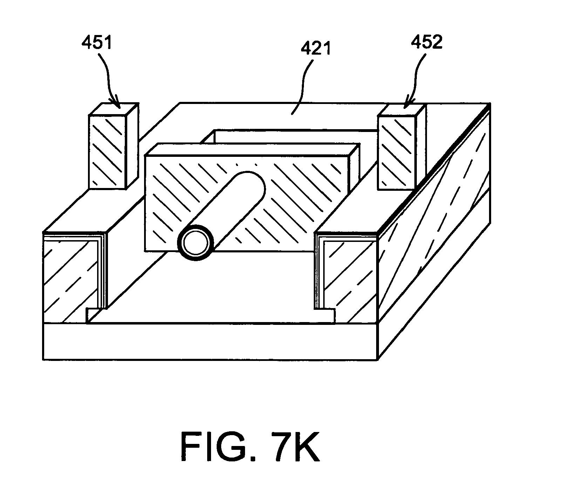

Une gravure isotrope du matériau 404 peut être ensuite réalisée de manière à libérer l'élément 421 (figure 7K).

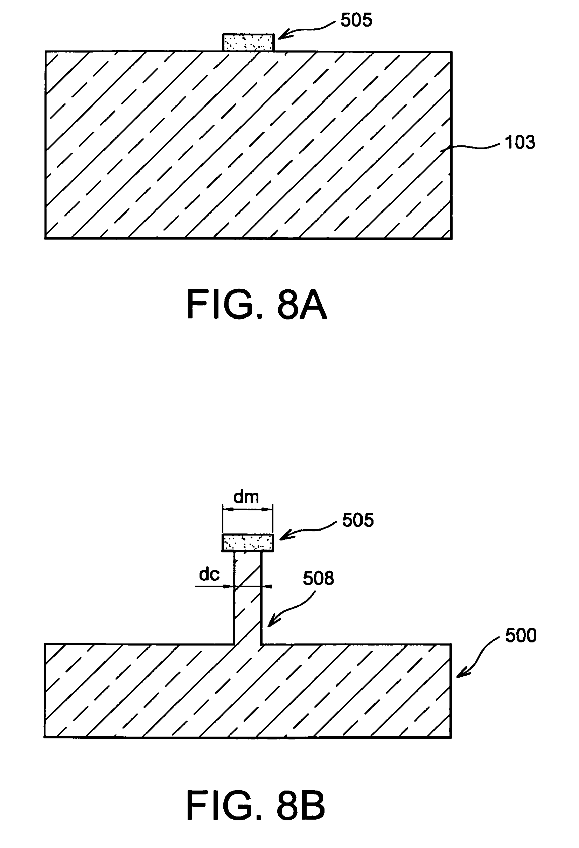

Un autre exemple de procédé de réalisation d'un composant électromécanique suivant l'invention pour système électromécanique, va à présent être donné en liaison avec les figures 8A-8E (les figures 8A-8E représentant une vue en coupe du composant en cours de réalisation, seuls les éléments situés dans le plan de coupe étant représentés sur ces figures).

On forme tout d' abord sur un substrat 500, par exemple un substrat « bulk » à base Si, ou un substrat de type semi-conducteur sur isolant tel qu'un substrat de type SOI (SOI pour « Silicon On Insulator » ou silicium sur isolant), ou par exemple une couche de SiC sur Si « bulk », ou par exemple une couche de substrat SiC sur Oxyde (SiCOI), un masquage 505.

Ce masquage 505 peut être réalisé par exemple par dépôt d'une couche de masquage par exemple à base de SiₓN_{y} ou de résine ou d'oxyde de silicium SiₓO_{y}, puis gravure de cette couche de masquage de manière à définir un ou plusieurs motifs du masquage (figure 8A).

On forme ensuite dans le support 500, au moins un barreau 508 destiné à former un organe fixe du composant électromécanique que l'on souhaite réaliser, le barreau 508 s'étendant dans une direction orthogonale au plan principal du support 500.

Le barreau 508 peut être réalisé par gravure anisotrope des parties support 500 qui ne sont pas protégées par le masquage 505.

Ensuite, on peut réduire les dimensions latérales du barreau 508, c'est à dire dans un plan parallèle au support, de manière à conférer au barreau 508 une dimension critique dc inférieure à la dimension critique Dm du masquage 505 reposant sur le barreau 508 (figure 8B). Cette réduction latérale du barreau 508 peut être effectuée par exemple à l'aide d'une gravure isotrope ou d'étapes successives d'oxydation et désoxydation du matériau du barreau lorsque par exemple ce dernier est à base de Si.

Puis, on dépose une couche de carbone amorphe 509, qui recouvre le support 500, les flancs du barreau 508 et le masquage 505. Le carbone amorphe déposé peut être conforme.

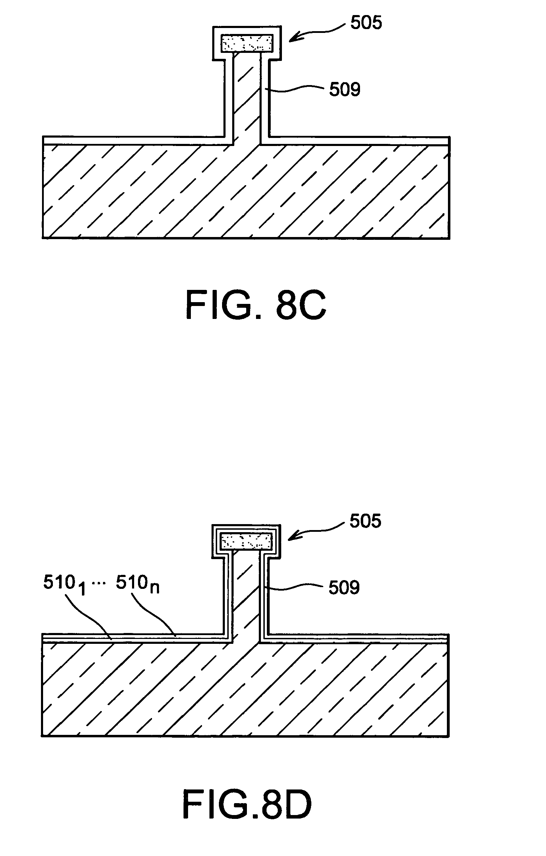

On réalise ensuite une graphénisation de cette couche de carbone amorphe 509, de manière à former ainsi un empilement de plusieurs couches, ou de feuillets 510₁,..., 510ₙ au moins un premier feuillet 510₁, et au moins un deuxième feuillet 510₂ sur le premier feuillet 510₁, recouvrent le barreau 508 (figure 8D).

On forme ainsi au moins un premier feuillet 510₁, qui est lié ou solidaire du barreau 508, et qui est destiné à former avec ce barreau 508, un organe fixe du composant électromécanique. On forme ainsi également au moins un deuxième feuillet libre 510₂, qui est disjoint du premier feuillet 510₁, et peut être déplacé en rotation autour du barreau 508 et du premier feuillet 510₁, le deuxième feuillet étant destiné à former une partie d'organe mobile du composant électromécanique.

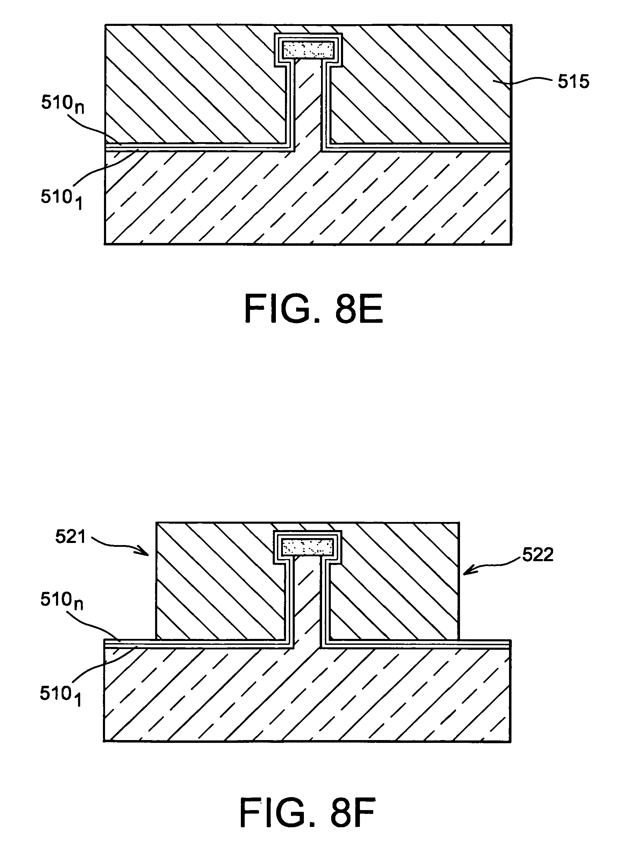

On forme ensuite autour, et sur le barreau 508 recouvert des feuillets 510₁,...,510ₙ, au moins une couche d'un matériau 515, dans lequel au moins élément d'organe mobile du composant électromécanique, par exemple sous forme d'ailettes est destiné à être réalisé. Le matériau 515 peut être par exemple un matériau métallique (figure 8E).

Une étape de polissage mécano-chimique (CMP) du matériau 515 peut être ensuite effectuée.

Puis, on défini dans le matériau 515, au moins un motif d'organe mobile de la structure, par exemple des motifs d'ailettes 521, 522 (figure 8F).

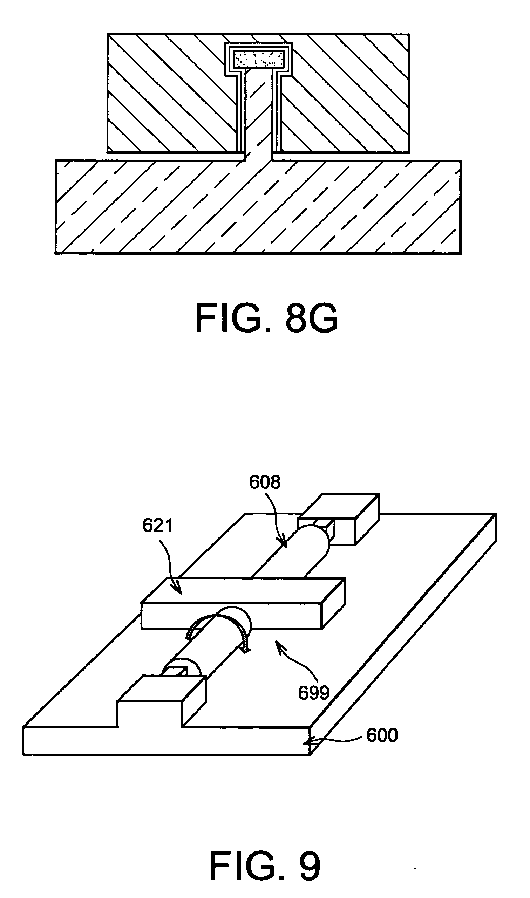

Ensuite, afin de libérer l'organe mobile, on effectue une gravure sélective des portions des feuillets 510₁,...,510ₙ de graphène reposant sur le support 500 et qui ne sont pas recouvertes par le matériau 515 des ailettes 521, 522. Ce retrait peut être éventuellement prolongé sous les ailettes 521, 522. Cette gravure sélective peut être réalisée par exemple à l'aide d'un plasma par exemple à l'aide d'un plasma O₂ (figure 8G).

Selon les différentes variantes qui ont été décrites on peut :
- mettre en oeuvre un procédé dans lequel on utilise au moins deux couches sacrificielles, avec une première couche sacrificielle servant à libérer le barreau pour la fabrication des ailettes, une deuxième utilisée pour libérer la structure,
- mettre en oeuvre un procédé dans lequel on utilise une seule couche sacrificielle pour libérer soit les ailettes soit la structure globale,
- mettre en oeuvre un procédé dans lequel les libérations successives sont réalisées par gravure partielle des matériaux.

Un composant électro-mécanique tel que décrit précédemment peut avoir de nombreuses applications, et peut être intégré dans tout micro-système ou nano-système dans lequel un mouvement de rotation autour d'un axe est mis en oeuvre.

Le composant électromécanique peut permettre par exemple de former un commutateur tel qu'un commutateur électrique ou optique.

Un commutateur avec 2 positions stables dont une position est mise en oeuvre par exemple à l'aide de forces de Van der Waals, ou par exemple à l'aide d'une force magnétique, peut être prévu.

Un exemple d'un tel commutateur est donné sur la figure 8, avec un organe mobile comportant une ailette 521 formant une bascule, l'ailette 521 tournant autour d'un axe formé par un barreau 508 rattaché à deux blocs d'ancrage reposant sur un support 500. Un actionnement électrostatique de l'ailette 521, peut être prévu avec une ou plusieurs électrodes (non représentées) positionnées soit latéralement de part et d'autre de l'ailette, soit en dessous de l'ailette. Un actionnement magnétique, peut être également prévu. Dans ce cas, la présence d'électrode n'est pas nécessaire pour un d'actionnement de type magnétique.

Un tel composant muni d'un tel barreau et d'un tel agencement de feuillets de graphène autour du barreau, permet de mettre en oeuvre un mouvement de rotation dans lequel les frottements sont diminués et I'efficacité énergétique est accrue. Les feuillets de graphène permettent de rendre faibles les frottements autour de l'axe en rotation, et de réaliser une rotation de l'élément mobile autour d'un axe sans torsion, ou avec une torsion négligeable ou très faible de cet élément formant l'axe de rotation.

Une telle torsion nécessiterait la mise en oeuvre d'un couple de rappel qu'il faudrait contre balancer via l'application de forces diverses pour maintenir le commutateur dans une position stable après actionnement.

Dans le cas présent, un maintien en position stable du commutateur peut même être mis en oeuvre à l'aide de forces de Van der Waals par exemple par collage entre l'ailette et une zone 599 sur le support 500 peut suffire à maintenir le commutateur dans une position stable donnée sans qu'une force complémentaire, par exemple magnétique ou électrostatique soit nécessaire.

Avec un tel agencement, le système électromécanique est plus efficace et plus robuste.

## Revendications

1. Procédé de réalisation d'un micro-système électromécanique doté d'au moins un organe fixe comprenant un barreau, et d'au moins un organe mobile en rotation autour d'au moins une portion du dit barreau, le procédé comprenant des étapes de :
a) formation, à partir d'une couche (102, 202, 302, 402) d'au moins un matériau donné (103, 203, 303, 403) reposant sur un support, d'au moins un barreau (108, 208, 308, 408, 508), ledit matériau donné étant compatible avec une croissance de feuillets de graphène, ou comportant au moins une épaisseur qui peut être traitée de manière à être décomposée et transformée en un empilement de plusieurs feuillets de graphène,
b) formation autour du barreau d'une pluralité de feuillets (110₁,..., 110ₙ, 410₁,..., 410ₙ) de graphène dont au moins un premier feuillet de graphène, et au moins un deuxième feuillet de graphène, séparé du premier feuillet et mobile par rapport au premier feuillet, le dit deuxième feuillet de graphène étant destiné à former une partie d'organe mobile du composant électromécanique.

2. Procédé selon la revendication 1, dans lequel, à l'étape a), au moins une gravure de ladite couche (102, 202, 302, 402) du dit matériau donné (103, 203, 303, 403) est réalisée pour former ledit barreau (108, 208, 308, 408).

3. Procédé selon l'une revendication 1 ou 2 dans lequel le matériau donné (103, 203, 303, 403) est un matériau, par exemple du Sic ou du cuivre (Cu) ou du Nickel (Ni) ou de l'iridium (Ir) ou du platine (Pt) ou du ruthenium (Ru) ou du Palladium (Pd) ou du carbone amorphe, sur lequel une croissance de graphène peut être réalisée ou dont au moins une épaisseur peut être décomposée en graphène.

4. Procédé selon l'une des revendications 1 à 3, le barreau (208, 508) étant réalisé à l'étape a), de manière à :
- former un angle non-nul avec le plan principal du support,
- ou à être parallèle au plan principal du support.

5. Procédé selon la revendication 4, le barreau (208, 508) étant réalisé à l'étape a), de manière à former un angle non-nul avec le plan principal du support, le barreau (508) étant formé par gravure à travers un masquage de dimension critiqué supérieure à celle du barreau, les feuillets étant réalisés lors de l'étape b) de manière à recouvrir le barreau et le masquage.

6. Procédé selon la revendication 4, le barreau (208, 508) étant réalisé à l'étape a), de manière à être parallèle au plan principal du support, le barreau (308, 408) étant rattaché à au moins une zone d'un bloc d'ancrage, ladite zone appartenant à ladite couche de matériau donné dans laquelle le barreau a été formé à l'étape a).

7. Procédé selon l'une des revendications 1 à 6, comprenant en outre : la formation sur le barreau d'au moins un élément (121, 122, 321, 421) de l'organe mobile solidaire du deuxième feuillet de graphène.

8. Procédé selon l'une des revendications 1 à 7, comprenant en outre entre l'étape a) et l'étape b), au moins une étape consistant à arrondir le profil du barreau.

9. Procédé selon l'une des revendications 1 à 8, au moins un des dits feuillets formant une couche continue autour du barreau et/ou les feuillets étant formés de sorte que le pourtour du barreau comporte plusieurs feuillets.

## Claims

1. Method of fabricating an electro-mechanical microsystem provided with at least one fixed part comprising a bar, and at least one mobile part in rotation around at least one portion of said bar, the method comprising the steps of:
a) formation in a layer (102, 202, 302, 402) of at least one given material(103, 203, 303, 403) resting on a support, of at least one bar (108, 208, 308, 408, 508), said given material being compatible with the growing of graphene sheets or comprising at least a thickness that can be treated so as to be decomposed in a pile of several graphene sheets,
b) formation around the bar of a plurality of sheets of graphene (110₁,...,110ₙ, 410₁,...410ₙ) of which at least a first graphene sheet, and at least one second graphene sheet, separated from the first sheet and mobile with respect to the first sheet, said second graphene sheet being intended to form a part of the mobile part of said electro-mechanical system.

2. Method according to claim 1, in which, during step a), at least one etch of said layer 102, 202, 302, 402) of said given material (103, 203, 303, 403) is carried out in order to form said bar (108, 208, 308, 408).

3. Method according to one of the claims 1 or 2 in which the given material (103, 203, 303, 403) is a material, for exemple SiC or Copper (Cu) or Nickel
(Ni), or Iridium (Ir), or Palladium (Pd) or amorphous Carbon, on which graphene growth can be carried out or of which at least one thickness can be decomposed into graphene.

4. Method according to one of the claims 1 to 3, the bar (208, 508) being fabricated during step a) in order to form a non-zero angle with the main plane of the support or in order to be parallel with the main plane of the support.

5. Method according to claim 4, in which the bar (508) is made in step a) so as to form a non-zero angle with the main plane of the support, the bar being formed via etching through a mask with critical dimension larger than same of the bar, during step b) the sheets being produced so as to cover the bar and the mask.

6. Method according to claim 4, in which the bar (508) is made in step a) so as to be parallel with the main plane of the support, the bar (308, 408) being connected to at least one area of the anchoring block, said area belonging to said layer of given material in which the bar has been formed during step a).

7. Method according to one of the claims 1 to 6, comprising in addition: the formation on the bar of at least one element (121, 122, 321, 421) of the mobile part rigidly attached to the second graphene sheet.

8. Method according to one of the claims 1 to 7, comprising, in addition, between step a) and step b), at least one step consisting of rounding the profile of the bar.

9. Method according to one of the claims 1 to 8, at least one of said sheets forming a continuous layer around the bar, and/or the sheets being formed so that the periphery of the bar comprises a plurality of sheets.

## Patentansprüche

1. Verfahren zur Herstellung eines elektromechanischen Mikrosystems mit wenigstens einem einen Stab umfassenden festen Organ und wenigstens einem beweglichen Organ, drehbar um wenigstens einen Teil des genannten Stabs, wobei das Verfahren die folgenden Schritte umfasst:
a) Ausbildung - ausgehend von einer Schicht (102, 202, 302, 402) aus wenigstens einem auf einem Träger ruhenden bestimmten Material (103, 203, 303, 403) -, wenigstens eines Stabs (108, 208, 308, 408, 508), wobei das genannte bestimmte Material kompatibel ist mit einem Graphenblätter-Wachstum, oder wenigstens eine Dicke umfasst, die so behandelt werden kann, dass es zersetzt und umgewandelt wird in einen Stapel von mehreren Graphenblättern,
b) Ausbildung, um den Stab herum, einer Vielzahl von Graphenblättern (110₁, ..., 110ₙ, 410₁, ..., 410ₙ), darunter wenigstens ein erstes Graphenblatt und wenigstens ein zweites Graphenblatt, getrennt von dem ersten Graphenblatt und beweglich in Bezug auf das erste Blatt, wobei das genannte zweite Graphenblatt dazu bestimmt ist, ein bewegliches Organteil des elektromechanischen Bauelements zu bilden.

2. Verfahren nach Anspruch 1, bei dem, in Schritt a), wenigstens eine Ätzung der genannten Schicht (102, 202, 302, 402) des genannten bestimmten Materials (103, 203, 303, 403) durchgeführt wird, um den genannten Stab (108, 208, 308, 408) auszubilden.

3. Verfahren nach einem der Ansprüche 1 oder 2, bei dem das bestimmte Material (103, 203, 303, 403) ein Material wie zum Beispiel SiC oder Kupfer (Cu) oder Nickel (Ni) oder Iridium (Ir) oder Platin (Pt) oder Ruthenium (Ru) oder Palladium (Pd) oder amorpher Kohlenstoff ist, auf dem ein Graphenwachstum realisiert werden kann oder von dem wenigstens eine Dicke zu Graphen zersetzt werden kann.

4. Verfahren nach einem der Ansprüche 1 bis 3, wobei der Stab (208, 508) in Schritt a) so realisiert wird, dass er:
- mit der Hauptebene des Trägers einen Nichtnullwinkel bildet,
- zur Hauptebene des Trägers parallel ist.

5. Verfahren nach Anspruch 4, bei dem der Stab (208, 508) in Schritt a) so realisiert wird, dass er mit der Hauptebene des Trägers einen Nichtnullwinkel bildet, wobei der Stab (508) dabei mittels Ätzung durch eine Maske von höherer kritischer Dimension als der des Stabs hindurch ausgebildet wird und die Blätter in Schritt b) so realisiert werden, dass sie den Stab und die Maske überdecken.

6. Verfahren nach Anspruch 4, bei dem der Stab (208, 508) in Schritt a) so realisiert wird, dass er parallel ist zur Hauptebene des Trägers, wobei der Stab (308, 408) mit wenigstens einem Bereich eines Verankerungsblocks verbunden ist und der genannte Bereich zu der genannten Schicht aus bestimmtem Material gehört, in der der Stab in Schritt a) ausgebindet worden ist.

7. Verfahren nach einem der Ansprüche 1 bis 6, außerdem umfassend: die Ausbildung wenigstens eines Elements (121, 122, 321, 421) des mit dem zweiten Graphenblatt verbundenen beweglichen Organs auf dem Stab.

8. Verfahren nach einem der Ansprüche 1 bis 7, außerdem zwischen dem Schritt a) und dem Schritt b) umfassend: wenigstens einen Schritt zum Runden des Profils des Stabs.

9. Verfahren nach einem der Ansprüche 1 bis 8, bei dem wenigstens eines der genannten eine kontinuierliche Schicht um den Stab herum bildenden Blätter und/oder die Blätter so geformt bzw. ausgebildet sind, dass der Umfang bzw. die Umrandung des Stabs mehrere Blätter umfasst.
